# FASCICULE DE BREVET EUROPEEN

(11) **EP 3 298 635 B1**
(45) Date de publication et mention de la délivrance du brevet: **05.06.2019**
(21) Numéro de dépôt: 16726657.6
(22) Date de dépôt: 18.05.2016
(51) Int. Cl.: H01L 41/047, H01L 41/193, H01L 41/29, H01L 41/113

(54) **PROCÉDÉ DE FABRICATION D'UN NANOGENERATEUR PIEZO-ELECTRIQUE, NANOGENERATEUR PIEZO-ELECTRIQUE OBTENU PAR CE PROCÉDÉ ET DISPOSITIF COMPORTANT UN TEL NANOGENERATEUR PIEZO-ELECTRIQUE**
VERFAHREN ZUR HERSTELLUNG EINES PIEZOELEKTRISCHEN NANOGENERATORS, DURCH DIESES VERFAHREN ERHALTENER PIEZOELEKTRISCHER NANOGENERATOR UND VORRICHTUNG MIT SOLCH EINEM PIEZOELEKTRISCHEN NANOGENERATOR
PROCESS FOR FABRICATING A PIEZOELECTRIC NANOGENERATOR, PIEZOELECTRIC NANOGENERATOR OBTAINED BY THIS PROCESS AND DEVICE INCLUDING SUCH A PIEZOELECTRIC NANOGENERATOR

(30) Priorité: 18.05.2015 FR 1554412
(43) Date de publication de la demande: 28.03.2018
(73) Titulaire: Commissariat à l'Énergie Atomique et aux Énergies Alternatives, 75015 Paris (FR); Centre National de la Recherche Scientifique (CNRS), 75016 Paris (FR); Ecole Polytechnique, 91120 Palaiseau (FR)
(72) Inventeur: CLOCHARD, Marie-Claude, 78500 Sartrouville (FR); GIUSEPPE, Melilli, 91015 Modica (IT); WEGROWE, Jean-Eric, 91370 Verrieres-le-Buisson (FR); WADE, Travis, 75014 Paris (FR); BALANZAT, Emmanuel, 14160 Anisy (FR); GIGLIO, Eric, 14000 Caen (FR)
(74) Mandataire: Gevers & Orès
(86) Numéro de dépôt international: PCT/IB2016/052897
(87) Numéro de publication internationale: WO 2016/185399

(56) Documents cités:
- WO-A1-2012/153050
- US-A1- 2008 171 251
- SEUNGNAM CHA ET AL: "Porous PVDF As Effective Sonic Wave Driven Nanogenerators", NANO LETTERS, vol. 11, no. 12, 14 décembre 2011 (2011-12-14), pages 5142-5147, XP055256938, US ISSN: 1530-6984, DOI: 10.1021/nl202208n cité dans la demande
- GRASSELLI M ET AL: "Making porous membranes by chemical etching of heavy-ion tracks in beta-PVDF films", NUCLEAR INSTRUMENTS & METHODS IN PHYSICS RESEARCH. SECTION B: BEAM INTERACTIONS WITH MATERIALS AND ATOMS, ELSEVIER BV, NL, vol. 236, no. 1-4, 1 juillet 2005 (2005-07-01), pages 501-507, XP027665207, ISSN: 0168-583X [extrait le 2005-07-01]
- FERT A ET AL: "Magnetic nanowires", JOURNAL OF MAGNETISM AND MAGNETIC MATERIALS, ELSEVIER SCIENCE PUBLISHERS, AMSTERDAM, NL, vol. 200, no. 1-3, 1 octobre 1999 (1999-10-01), pages 338-358, XP004364022, ISSN: 0304-8853, DOI: 10.1016/S0304-8853(99)00375-3
- YAMAKI T ET AL: "Ion-track membranes of fluoropolymers: Toward controlling the pore size and shape", NUCLEAR INSTRUMENTS & METHODS IN PHYSICS RESEARCH. SECTION B: BEAM INTERACTIONS WITH MATERIALS AND ATOMS, vol. 314, 1 novembre 2013 (2013-11-01), pages 77-81, XP028755400, ISSN: 0168-583X, DOI: 10.1016/J.NIMB.2013.05.028

## Description

L'invention concerne un procédé de fabrication d'un nanogénérateur piézo-électrique.

Elle concerne également un nanogénérateur piézo-électrique obtenu par ce procédé de fabrication ainsi qu'un dispositif comportant un tel nanogénérateur piézo-électrique.

Un procédé de fabrication d'un nanogénérateur piézo-électrique est proposé dans l'article de Cha & al., « Nanoporous PVDF as effective sonic wave dirven nanogenerators », dans Nano Letters (2011), 11, 5142-5147.

Les étapes principales du procédé de fabrication proposé dans cet article sont les suivantes :
- anodisation d'une membrane en alumine pour créer des nanopores ;
- dépôt d'une couche métallique (dorure pour contact électrique);
- électrodéposition d'un métal dans les nanopores ;
- coulage d'un polymère, le PVDF, à l'état fondu dans les nanopores ;
- dissolution de l'alumine ;
- application d'une pression élevée pour changer la phase alpha (non organisée) en phase beta (potentiellement piézoélectrique) ;
- application d'un champ électrique élevée pour polariser le PVDF en phase beta et ainsi le rendre piézoélectrique ;
- dépôt d'une autre couche métallique (dorure pour l'autre contact électrique).

Ce procédé de fabrication est difficile à mettre en oeuvre, en particulier pour gérer la densité des pores.

De plus, les propriétés piézoélectriques du nanogénérateur piézoélectrique ainsi fabriqué sont limitées par les propriétés piézoélectriques du PVDF en phase beta polarisé.

L'article de M. Grasseli et N. Betz, « Making porous membranes by chemical etching of heavy-ions tracks in β-PVDF films », dans Nuclear instruments and Methods in Physics Research B (2005), 236, 501-507, divulgue un procédé de fabrication de membranes en PVDF nanoporeuses par irradiation aux ions lourds, puis gravure chimique. En variant la température, le temps de gravure et les agents de gravure, il est notamment mis en évidence que la taille et la forme des nanopores peuvent être modifiées sans dégrader la surface. Il n'est pas mis en évidence un avantage sur les propriétés piézo-électriques des échantillons réalisés.

L'article de A. Fert et L. Piraux, « Magnetic nanowires » dans Journal of Magnetism and Magnetic Materials (1999), 200, 338-358, propose une revue sur les nanofils magnétiques. Il est divulgué une méthode de fabrication de tels nanofils à partir de membranes en polymère, notamment à base de PVDF, nanoporeuses. Les membranes sont fabriquées par un procédé d'irradiation aux ions lourds puis gravées dans un milieu déterminé. Il est indiqué qu'un tel procédé de fabrication des membranes permet de contrôler la taille, la densité et la forme des pores. Il n'est pas mentionné d'avantage quant aux propriétés piézo-électriques.

Un objectif de l'invention est ainsi de proposer un procédé de fabrication plus aisé à mettre en oeuvre et permettant d'obtenir des propriétés piézoélectriques accrues.

Pour atteindre cet objectif, il est ainsi proposé un procédé de fabrication d'un nanogénérateur piézo-électrique comprenant les étapes suivantes :
a) fournir une membrane en β-PVDF polarisé ou en copolymère PVDF-TrFe polarisé présentant donc des propriétés piézo-électriques, ladite membrane présentant par ailleurs deux faces externes principales séparées par une épaisseur e de membrane ;
b) irradier ladite membrane par l'une au moins de ses deux faces externes principales à travers toute l'épaisseur de ladite membrane avec des ions lourds présentant une fluence comprise entre 10³ ions/cm² et 10¹⁰ ions/cm², en conséquence de quoi on obtient une membrane avec des traces latentes du passage des ions lourds à travers toute l'épaisseur de celle-ci ;
c) réaliser une révélation chimique des traces latentes sur une durée prédéterminée pour maintenir une zone de défaut appartenant à la trace latente, en conséquence de quoi on obtient une membrane nanostructurée avec des nanopores comportant, autour de chaque nanopore, une zone de défaut :
d) déposer une couche d'un matériau conducteur de l'électricité sur l'une des deux faces externes principales de ladite membrane ;
e) réaliser une électrodéposition d'un matériau semi-conducteur ou conducteur de l'électricité dans les nanopores en arrêtant l'électrodéposition avant le remplissage complet des nanopores, en conséquence de quoi on obtient une membrane nanostructurée avec des nanofils remplissant partiellement les nanopores ; et
f) déposer une couche d'un matériau conducteur de l'électricité sur l'autre des deux faces externes principales, qui n'est donc pas en contact avec les nanofils.

Le procédé de fabrication conforme à l'invention pourra également mettre en oeuvre les étapes suivantes, prises seules ou en combinaison :
- pour irradier, pendant l'étape b), ladite membrane à travers toute l'épaisseur de celle-ci, les ions lourds présentent une énergie comprise entre 2MeV/uma et 15MeV/uma ;
- l'étape b) d'irradiation s'effectue avec des ions lourds de type Kr ou Xe ;
- l'étape b) d'irradiation s'effectue avec des ions lourds dont la fluence est comprise entre 10³ ions/cm² et 10⁹ ions/cm², par exemple entre 10⁶ ions/cm² et 10⁹ ions/cm² ;
- l'étape b) d'irradiation s'effectue sous atmosphère inerte, par exemple sous hélium ;
- l'étape c) de révélation chimique est réalisée par hydrolyse basique avec une solution aqueuse de KOH à 10N et KMnO₄ à 0,25N, à une température comprise entre 40°C et 75°C, par exemple entre 40°C et 70°C, et de préférence à 65°C ;
- ledit procédé de fabrication comprend, en sus, les étapes suivantes A) à F) suivantes :
   A) mettre en oeuvre les étapes a) à e), où l'étape b) est réalisée avec une fluence comprise entre 10³ ions/cm² et 5.10⁹ ions/cm², de préférence entre 10³ ions/cm² et 10⁸ ions/cm², et l'étape e) d'électrodéposition formant des nanofils réalisés avec un premier matériau semiconducteur ou conducteur électrique ;
   B) répéter les étapes b) et c), ce qui permet de réaliser d'autres nanopores, l'étape b) étant réalisée avec une fluence comprise entre 10³ ions/cm² et 5.10⁹ ions/cm², de préférence entre 10³ ions/cm² et 10⁸ ions/cm², ;
   C) supprimer la couche en matériau conducteur de l'électricité déposée à l'étape d) ;
   D) mettre en oeuvre l'étape f), si bien qu'on définit une couche en matériau conducteur de l'électricité, qui n'est pas en contact avec les nanofils (15), sur une face externe principale de ladite membrane ;
   E) répéter l'étape e) d'électrodéposition pour former d'autres nanofils dans lesdits autres nanopores avec un deuxième matériau semiconducteur ou conducteur électrique, différent du premier matériau semiconducteur ou conducteur électrique ; et
   F) répéter l'étape d).
- ledit procédé comprend en sus les étapes A') à H') suivantes :
   A') mettre en oeuvre les étapes a) à d), l'étape a) étant réalisée avec une première membrane dite membrane source ;
   B') mettre en oeuvre les étapes a) à c), l'étape a) étant réalisée avec une autre membrane dite membrane objet ;
   C') disposer la membrane objet obtenue à l'issue de l'étape B') sur la membrane source obtenue à l'issue de l'étape A') ;
   D') mettre en oeuvre l'étape e), cette étape d'électrodéposition permettant de remplir partiellement chacun des nanopores formé par l'association d'au moins un nanopore de la membrane objet obtenue à l'issue de l'étape B'), lequel nanopore se superpose à au moins un nanopore de la membrane source obtenue à l'issue de l'étape A') pour former des nanofils réalisés avec un premier matériau semiconducteur ou conducteur électrique, les autres nanopores n'étant pas remplis ;
   E') séparer les deux membranes l'une de l'autre ;
   F') mettre en oeuvre l'étape f) sur la membrane objet obtenue à l'issue de l'étape E') si bien qu'on définit une couche conductrice de l'électricité, qui n'est pas en contact avec les nanofils, sur une face externe principale de ladite membrane ;
   G') mettre en oeuvre l'étape e) d'électrodéposition sur la membrane objet obtenue à l'issue de l'étape F') pour former des nanofils dans lesdits autres nanopores avec un deuxième matériau semiconducteur ou couducteur électrique, différent du premier matériau semiconducteur ou conducteur électrique ; et
   H') mettre en oeuvre l'étape d) sur la membrane objet obtenue à l'issue de l'étape G') ;
- ledit procédé est tel que le premier matériau formant des nanofils est un matériau semiconducteur présentant des propriétés photovoltaïques et le deuxième matériau formant les autres nanofils est un matériau semiconducteur présentant des propri étés thermoélectriques.

L'invention propose également un nanogénérateur piézo-électrique comprenant :
- une membrane en β-PVDF polarisé ou en copolymère PVDF-TrFe polarisé présentant donc des propriétés piézo-électriques, ladite membrane présentant par ailleurs deux faces externes principales séparées par une épaisseur e de membrane ;
- une première couche réalisée en un matériau conducteur électrique recouvrant l'une des deux faces externes principales de la membrane ;
- une deuxième couche réalisée en un matériau conducteur électrique recouvrant l'autre des deux faces principales externes de la membrane ;
ladite membrane étant, dans son épaisseur, nanostracturée par au moins un ensemble de nanofils semiconducteurs ou conducteurs électriques, par exemple métalliques, selon une densité surfacique comprise entre 10³ nanofils/cm² et 10¹⁰ nanofils/cm², lesdits nanofils étant connectés à la première couche mais pas à la deuxième couche, et
ladite membrane comportant, autour des nanofils, des zones de défaut (ZD) laissées par le passage des ions lourds à travers toute l'épaisseur de cette membrane pour créer des nanopores accueillant lesdits nanofils.

Ce nanogénérateur piézo-électrique pourra comporter les caractéristiques suivantes, prises seules ou en combinaison :
- la membrane est, dans son épaisseur, nanostructurée par un premier ensemble de nanofils 15, 15', 15" semiconducteurs ou conducteurs électriques, par exemple métalliques, selon une densité surfacique comprise entre 10³ nanofils/cm² et 5.10⁹ nanofils/cm², lesdits nanofils 15, 15', 15" étant connectés à la première couche 14 mais pas à la deuxième couche 16, un deuxième ensemble de nanofils 150 semiconducteurs ou conducteurs électriques, par exemple métalliques, selon une densité surfacique comprise entre 10³ nanofils/cm² et 5.10⁹ nanofils/cm², nanofils 150 de ce deuxième ensemble de nanofils 150 étant connectés à la deuxième couche 16 mais pas à la première couche 14, ladite membrane 100 comportant, autour des nanofils 15, 15', 15", 150, des zones de défaut ZD laissées par le passage des ions lourds à travers toute l'épaisseur de cette membrane 100 pour créer des nanopores accueillant lesdits nanofils 15, 15', 15", 150 des deux ensembles de nanofils 15, 15', 15", 150;
- les nanofils du ou de l'un au moins des ensembles de nanofils est réalisé un matériau conducteur de l'électricité de type métallique, par exemple Au, Zn, Cu, Co, Ni, Ag ou Pt ou un alliage métallique, par exemple formé avec les métaux précités ;
- les nanofils du ou de l'un au moins des ensembles de nanofils est réalisé en un matériau semiconducteur présentant des propriétés photovoltaïques, par exemple le ZnO, ou thermoélectriques, par exemple le Bi₂Te₃ ou le Sb₂Te₃.
- les nanofils sont cylindriques et/ou coniques ;
- les nanofils, cylindriques, présentent un diamètre compris entre 20nm et 110nm ;
- la densité surfacique des nanofils du ou de chaque ensemble de nanofils est comprise entre 10³ nanofils/cm³ et 10⁹ nanofils/cm², par exemple entre 10⁶ nanofils/cm² et 10⁹ nanofils/cm² ;
- l'épaisseur e de la membrane pourra être comprise entre 1µm et 60µm, par exemple de l'ordre de 10µm, en particulier 10µm pour du β-PVDF et 11µm pour du copolymère P(VDF-TrFE),

L'invention propose encore un dispositif comprenant :
- un nanogénérateur piézo-électrique selon l'invention ;
- un condensateur ;
- un moyen, disposé entre le nanogénérateur piézo-électrique et le condensateur, pour transférer le courant sortant du nanogénérateur piézo-électrique vers le condensateur sans possibilité de retour vers le nanogénérateur piézo-électrique, par exemple un pont de Graetz.

Ce dispositif pourra comprendre les caractéristiques suivantes, prises seules ou en combinaison :
- le condensateur est un nanocondensateur comportant :
   - une membrane, réalisée en un matériau isolant électrique, présentant deux faces externes principales séparées par une épaisseur de membrane ;
   - une première couche réalisée en un matériau conducteur électrique recouvrant l'une des deux faces externes principales de la membrane ;
   - une deuxième couche réalisée en un matériau conducteur électrique recouvrant l'autre des deux faces externes de la membrane ;
   ladite membrane étant, dans son épaisseur, nanostructurée d'une part, par un premier ensemble de nanofils semiconducteurs ou conducteurs électriques, par exemple métalliques, connectés à la première couche conductrice de l'électricité mais pas à la deuxième couche conductrice de l'électricité et d'autre part, par un deuxième ensemble de nanofils semiconducteurs ou conducteurs électriques, par exemple métalliques, connectés à la deuxième couche conductrice de l'électricité mais pas à la première couche conductrice de l'électricité, lesdits nanofils du premier ensemble de nanofils et du deuxième ensemble de nanofils étant interdigités ;
- la membrane du nanocondensateur est réalisée en un matériau choisi parmi : le polycarbonate (PC), l'alumine (Al₂O₃), le polyéthylènetérephtalate (PET) ou le polyimide (PI), avantageusement du Kapton® ;
- les nanofils de l'un quelconque du premier et du deuxième ensemble de nanofils sont des nanofils métalliques choisis parmi : Au, Zn, Cu, Co, Ni, Ag, Pt ou un alliage métallique, en particulier réalisé à partir des métaux précités.

D'autres caractéristiques, buts et avantages de l'invention ressortiront à la lecture de la description faite en référence aux figures annexés données à titre d'exemple, et dans lesquelles :

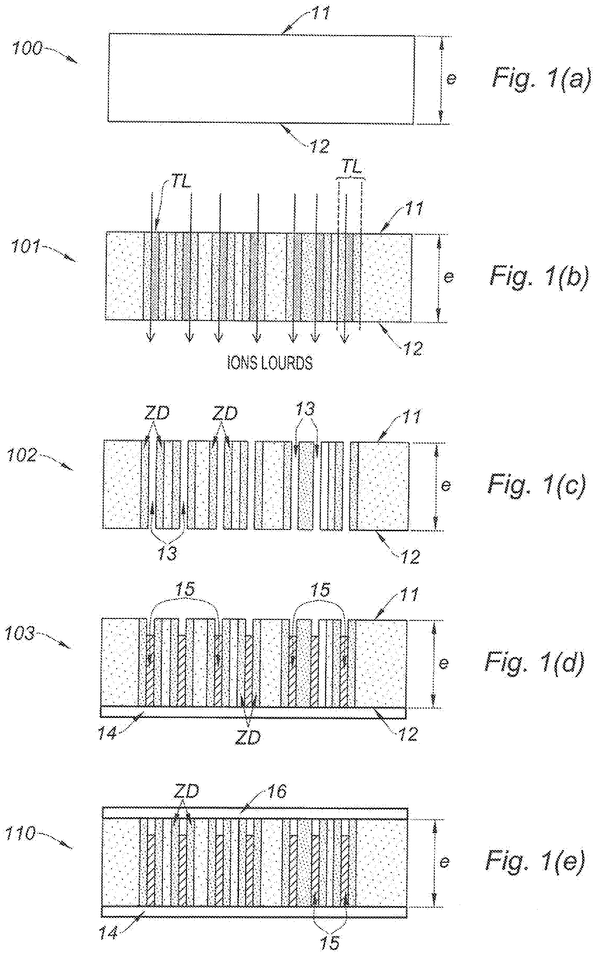

- la figure 1, qui comprend les figures 1(a) à 1(e), représente, sur les figures 1(a) à 1(d), différentes membranes intermédiaires obtenues au cours de la fabrication d'un nanogénérateur piézo-électrique conforme à l'invention comportant des nanofils cylindriques, lequel est représenté sur la figure 1(e) ;

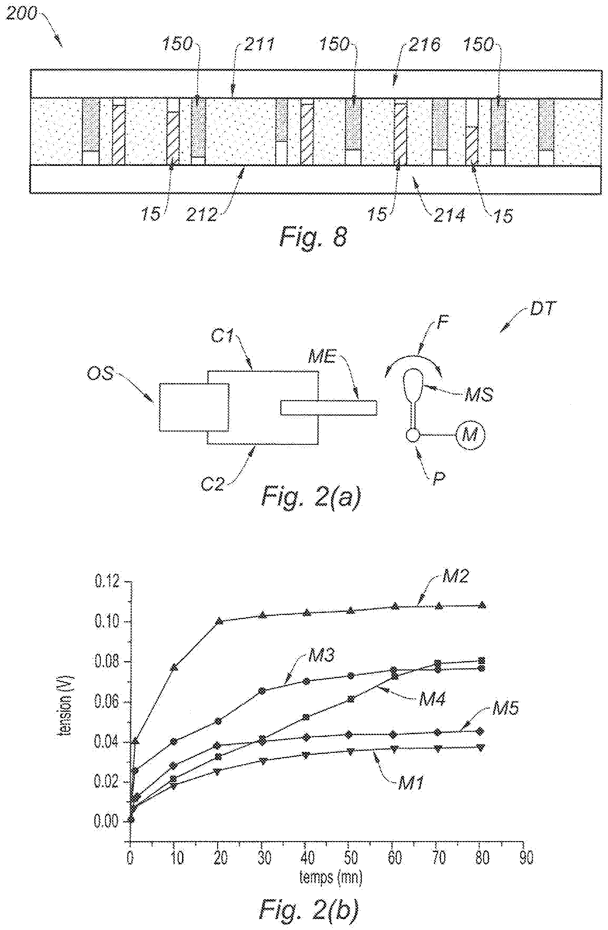

- la figure 2, qui comprend les figures 2(a) et 2(b), où la figure 2(a) est un schéma représentatif d'un dispositif de test et la figure 2(b), des résultats d'essais ;

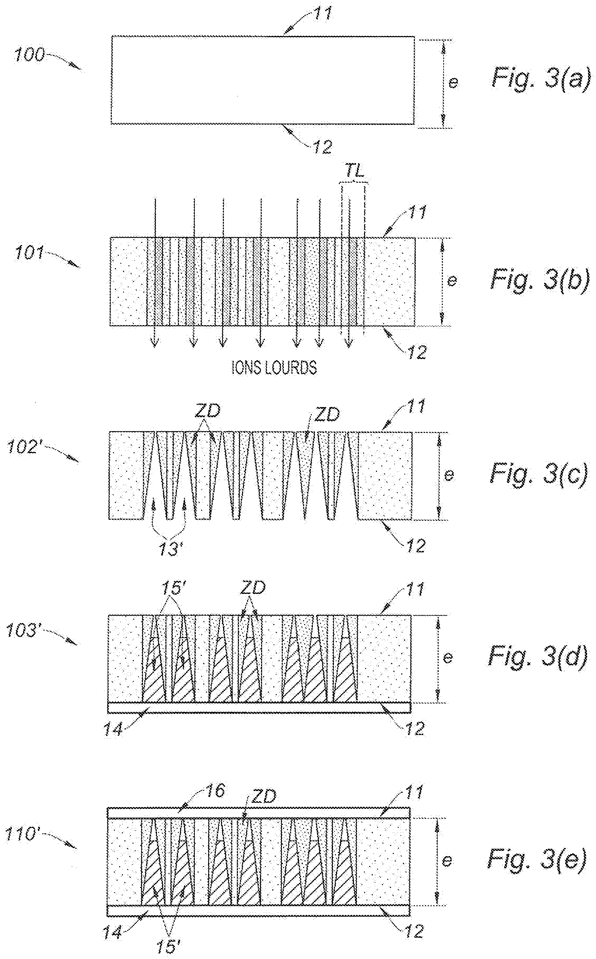

- la figure 3, qui comprend les figures 3(a) à 3(e), représente, sur les figures 3(a) à 3(d), différentes membranes intermédiaires obtenues au cours de la fabrication d'un nanogénérateur piézo-électrique conforme à l'invention comportant des nanofils coniques réalisés au sein d'une membrane avec des nanopores coniques, ce nanogénérateur étant représenté sur la figure 3(e) ;

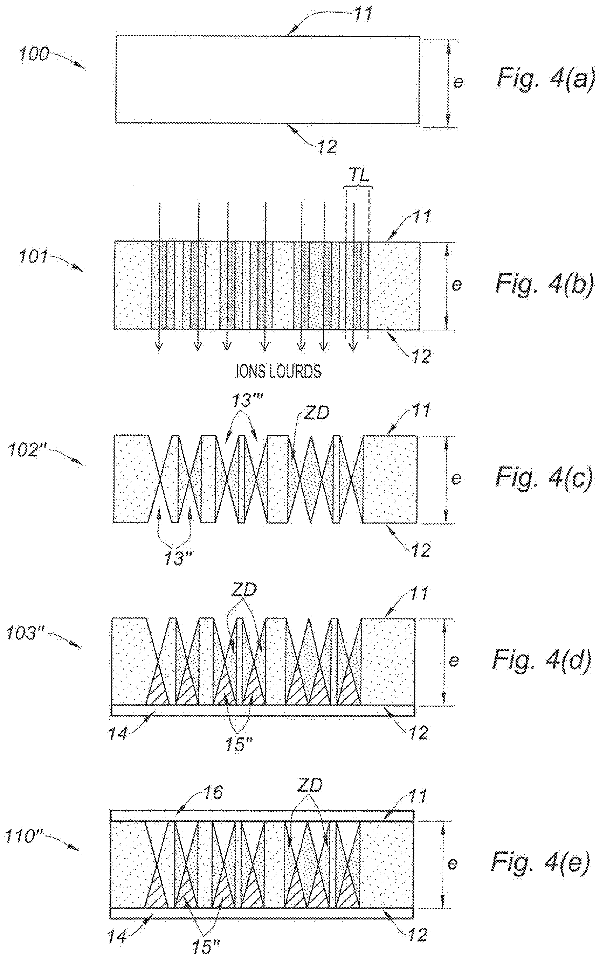

- la figure 4, qui comprend les figures 4(a) à 4(e), représente, sur les figures 4(a) à 4(d), différentes membranes intermédiaires obtenues au cours de la fabrication d'un nanogénérateur piézo-électrique conforme à l'invention comportant des nanofils coniques réalisés au sein d'une membrane avec des nanopores bi-coniques, ce nanogénérateur étant représenté sur la figure 4(e) ;

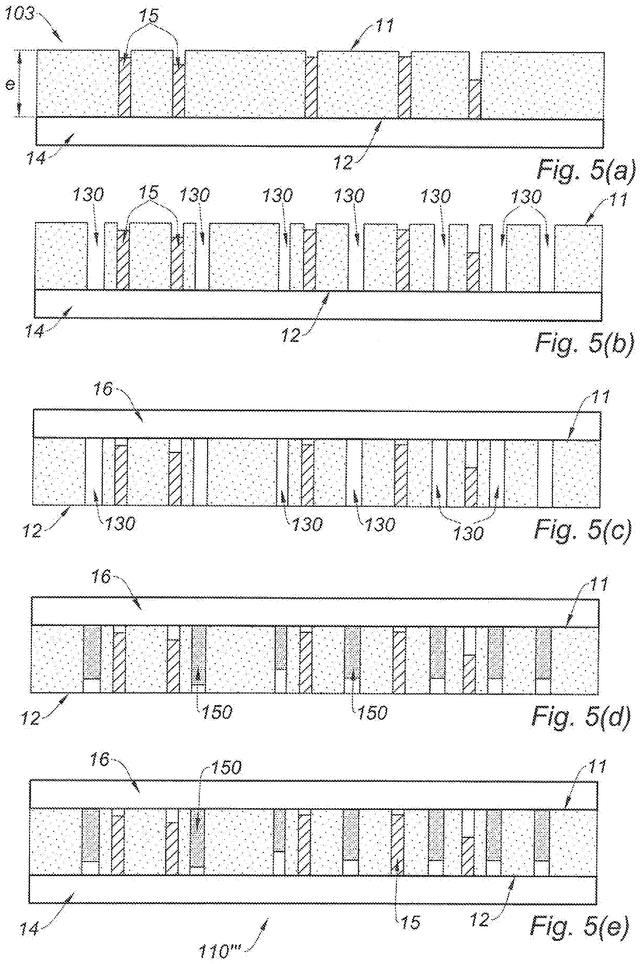

- la figure 5, qui comprend les figures 5(a) à 5(e), représente, sur les figures 5(a) à 5(d), différentes membranes intermédiaires obtenues au cours de la fabrication d'un nanogénérateur piézo-électrique conforme à l'invention, selon une variante de réalisation, comportant des nanofils cylindriques, ce nanogénérateur étant représenté sur la figure 5(e) ;

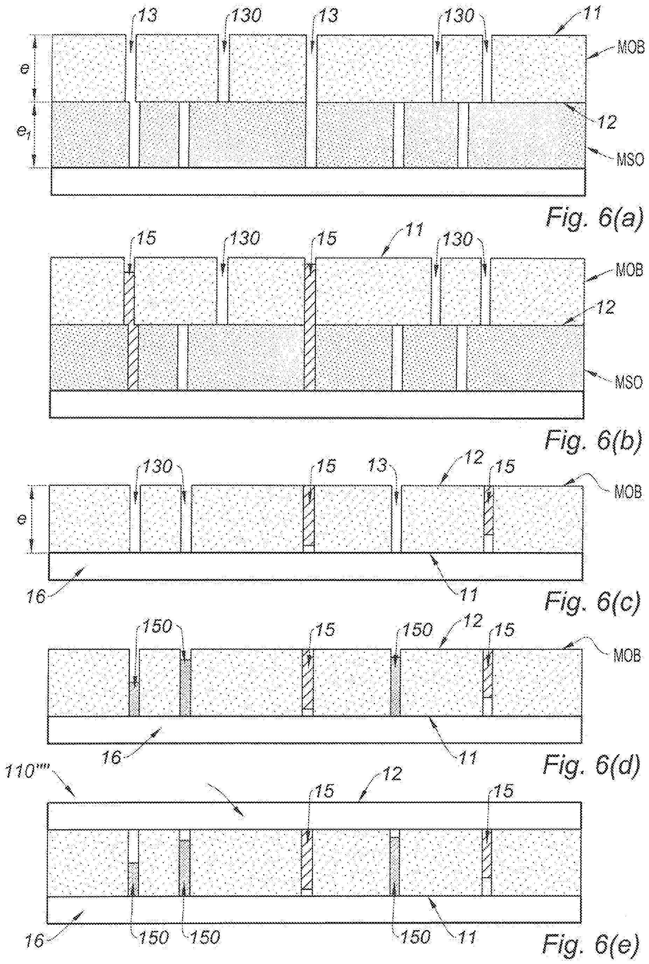

- la figure 6, qui comprend les figures 6(a) à 6(e), représente, sur les figures 6(a) à 6(d), différentes membranes intermédiaires obtenues au cours de la fabrication d'un nanogénérateur piézo-électrique conforme à l'invention, selon une autre variante de réalisation, comportant des nanofils cylindriques, ce nanogénérateur étant représenté sur la figure 6(e) ;

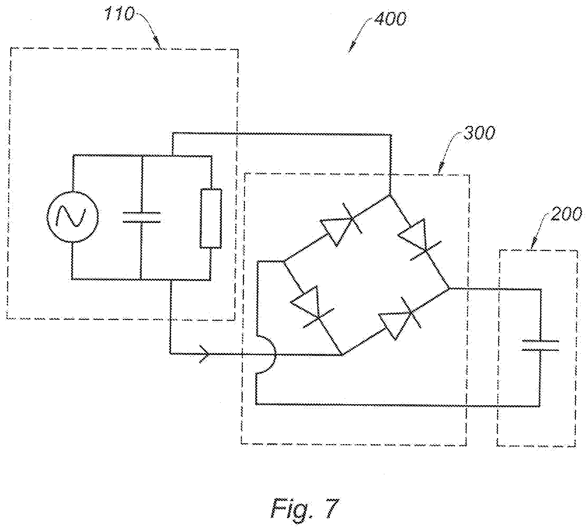

- la figure 7 représente un dispositif comprenant un nanogénérateur piézo-électrique conforme à l'invention et un condensateur pour stocker l'énergie produite par le nanogénérateur ;
- la figure 8 représente la structure d'un nanocondensateur pouvant être utilisé dans le dispositif illustré sur la figure 7.

Sur la figure 1, on a représenté les structures obtenues à l'issue des différentes étapes d'un procédé de fabrication d'un nanogénérateur piézo-électrique conforme à l'invention.

Tout d'abord, au cours d'une étape a), on fournit une membrane 100 en β-PVDF polarisé ou en copolymère P(VDF-TrFE) polarisé, ladite membrane présentant deux faces externes principales 11, 12 séparées par une épaisseur e de membrane 100.

On pourra se référer à la figure 1(a).

Le β-PVDF est un polyfluorure de vinylidène en phase beta.

Le copolymère P(VDF-TrFE) est constitué de deux monomères : le difluorure de vinylidène (VDF) et le trifluorure d'éthylène (TrFE). La proportion du motif de PVDF dans de ce copolymère peut varier entre 60% et 80% en moles, la proportion du motif de TrFE assurant le complément, à savoir entre 20% et 40% en moles. Avantageusement, on utilisera un copolymère P(VDF-TrFE) avec une répartition 70% (VDF) versus 30% (TrFE) en moles.

L'épaisseur e de la membrane 100 pourra être comprise entre 1µm et 60µm, par exemple de l'ordre de 10µm, en particulier 10µm pour du β-PVDF et 11µm pour le copolymère P(VDF-TrFE).

Puis, au cours d'une étape b), on irradie la membrane par l'une au moins de ses deux faces externes 11, 12 principale, en l'occurrence la face 11, à travers toute l'épaisseur e de ladite membrane 100. Ceci s'effectue avec des ions lourds présentant une fluence comprise entre 10³ ions/cm² et 10¹⁰ ions/cm².

On obtient alors une membrane 101 avec des traces latentes TL du passage des ions lourds à travers toute l'épaisseur e de celle-ci et présentant des propriétés piézo-électriques accrues par rapport à la membrane fournie à l'étape a). Cette membrane 101 est représentée sur la figure 1(b).

L'accroissement des propriétés piézo-électriques est un effet inattendu, qui sera mis en évidence à l'appui d'une série d'essais présentée ultérieurement.

Avantageusement, la fluence des ions lourds sera comprise entre 10³ ions/cm³ et 10⁹ ions/cm². Encore plus avantageusement, la fluence sera comprise entre 10⁶ ions/cm² et 10⁹ ions/cm², voire entre 10⁷ et 10⁹ ions/cm².

Pour irradier ladite membrane 100 à travers toute l'épaisseur de celle-ci, les ions lourds présenteront avantageusement une énergie comprise entre 2MeV/uma et 15MeV/uma ; où « uma » désigne une unité de masse atomique (« mau » pour « mass atomic unit » selon la terminologie anglo-saxonne).

Cette énergie dépendra de l'épaisseur de la membrane 101 et de la nature chimique de celle-ci, β-PVDF ou copolymère P(VDF-TrFE)
Ceci peut notamment être obtenu avec des ions lourds de type Kr ou Xe, accélérés pour obtenir ce niveau d'énergie permettant de traverser toute l'épaisseur de la membrane.

Avantageusement, l'irradiation s'effectue sous atmosphère inerte, par exemple sous hélium. Sous atmosphère inerte, on évite toute oxydation potentielle des radicaux créés, dans la membrane, par l'irradiation aux ions lourds.

De manière avantageuse, et comme illustré sur la figure 1(b), l'irradiation s'effectue avec un flux d'ions lourds perpendiculaire à l'une des faces principales externes, en l'occurrence la face 11, de sorte que les traces latentes présentent une forme cylindrique.

Ensuite, au cours d'une étape c), on réalise une révélation chimique des traces latentes sur une durée prédéterminée pour maintenir une zone de défaut appartenant à la trace latente. Il convient de noter que le diamètre des nanopores (nm) Dₙ varie linéairement avec le temps t (mn) selon la relation Dₙ = 1,6*t.

Dans le cas d'espèce, on a représenté un cas où les nanopores, cylindriques, traversent toute l'épaisseur de membrane. Cependant, d'autres formes peuvent être envisagées pour les nanopores, par exemple coniques ou bi-coniques comme cela sera détaillé par la suite.

On obtient alors, 3 l'issue de cette étape c), une membrane nanostructurée 102 avec des nanopores 13, en l'occurrence cylindriques et traversant tout l'épaisseur de la membrane 102, avec des zones de défaut autour de chaque nanopore 13, comme représenté sur la figure 1(c).

L'étape de révélation chimique peut s'effectuer par hydrolyse basique à une température comprise entre 40°C et 75°C et avec une solution aqueuse de KOH à 10N et KMnO₄ à 0,25N. Avantageusement, l'hydrolyse basique sera réalisée entre 40°C et 70°C, de préférence à 65°C.

Puis, au cours d'une étape d), on réalise un dépôt d'une couche d'un matériau conducteur de l'électricité sur l'une des faces principales externes 11, 12 de ladite membrane 102, en l'occurrence la face 12. Ce dépôt peut être effectué par pulvérisation cathodique.

Le matériau utilisé pour réaliser l'étape d) peut être un matériau conducteur de l'électricité de type métallique. Par exemple, il peut s'agir d'or (Au), de zinc (Zn), de cuivre (Cu), de cobalt (Co), de nickel (Ni), d'argent (Ag) ou de platine (Pt) ou un alliage métallique, en particulier formé à partir des métaux précités.

Ensuite, au cours d'une étape e), on réalise une électrodéposition d'un matériau semiconducteur ou conducteur de l'électricité dans les nanopores 13 en arrêtant l'électrodéposition avant le remplissage complet des nanopores 13.

On obtient alors une membrane nanostructurée 103 comportant une membrane nanostructurée 102 comportant, sur l'une de ses faces principales externes 11, 12, en l'occurrence la face 12, une couche 14 dudit matériau conducteur de l'électricité (étape d)) et des nanofils 15, comme cela est représenté sur la figure 1(d). La couche 14 et les nanofils 15 sont d'un seul tenant. Les nanofils 15 ne remplissent pas toute la hauteur des nanopores 13.

Le matériau utilisé pour réaliser l'étape e) d'électrodéposition peut être un matériau conducteur de l'électricité de type métallique, Par exemple, il peut s'agir d'or (Au), de zinc (Zn), de cuivre (Cu), de cobalt (Co), de nickel (Ni), d'argent (Ag) ou de platine (Pt) ou un alliage métallique, en particulier formé à partir des métaux précités. En pratique, l'étape e) d'électrodéposition peut être réalisée en plongeant la membrane nanostructurée obtenue à l'issue de l'étape d) dans un bain électrolytique acide, par exemple avec un pH de 6,2, comportant les ions métalliques concernés avec une concentration comprise entre 10% et 50% en poids.

En variante, le matériau utilisé pour réaliser l'étape e) peut être un matériau semiconducteur présentant des propriétés photovoltaïques. On peut ainsi définir un nanogénérateur piézo-électrique présentant par ailleurs des propriétés photovoltaïques. Un exemple de matériau semiconducteur présentant de telles propriétés photovoltaïques est l'oxyde de zinc (ZnO). Le ZnO est par ailleurs particulièrement intéressant puisqu'il présente également des propriétés piézo-électriques. En pratique, l'étape e) d'électrodéposition peut alors être réalisée en plongeant la membrane nanostructurée obtenue à l'issue de l'étape d) dans un bain électrolytique : 13,6g/l de ZnO ; 25g/l de KCl (tension de dépôt : -1200mV avec Ag/AgCl)
Selon une autre variante, il est envisageable de prévoir un matériau semiconducteur présentant des propriétés thermoélectriques pour réaliser l'étape e). On peut ainsi définir un nanogénérateur piézo-électrique présentant par ailleurs des propriétés photoélectriques. Un exemple de matériau semiconducteur présentant de telles propriétés photoélectriques est le tellurure de bismuth (Bi₂Te₃) ou le tellurure d'antimoine (Sb₂Te₃). En pratique, l'étape e) d'électrodéposition peut alors être réalisée en plongeant la membrane nanostructurée obtenue à l'issue de l'étape d) dans un bain électrolytique pour le Bi₂Te₃ : 3,63 g/l de Bi(NO₃)₃-5H₂O ; 1,276 g/l de Te et 64ml/l de HNO₃ (tension de dépôt : -140mV avec Ag/AgCl) et pour le Sb₂Te₃ : 8,7g/l de SbCl₃ ; 1,276 g/l de Te ; 50g/l de Na-L-tartrate et 64ml/l de HNO₃ (tension de dépôt : -100mV avec Ag/AgCl).

L'utilisation d'un matériau semiconducteur présentant des propriétés photovollaiques ou photoélectriques a l'avantage de procurer une fonction complémentaire à la piézo-électricité du nanogénérateur.

Plus encore, l'utilisation d'un matériau semiconducteur permet d'améliorer les performances du nanogénérateur piézo-électrique, lorsque ce dernier subit, selon le cas, une illumination ou une contrainte thermique
Enfin, au cours d'une étape f), on réalise un dépôt d'une couche d'un matériau conducteur de l'électricité sur l'autre des faces principales externes 11, 12 de ladite membrane 102, en l'occurrence la face 11. Ce dépôt peut être effectué par pulvérisation cathodique.

De ce fait, on définit une deuxième couche 16 dudit matériau qui n'est pas en contact avec les nanofils 15.

Le matériau utilisé pour réaliser l'étape f) peut être un matériau conducteur de l'électricité de type métallique. Par exemple, il peut s'agir d'or (Au), de zinc (Zn), de cuivre (Cu), de cobalt (Co), de nickel (Ni), d'argent (Ag) ou de platine (Pt) ou un alliage métallique, en particulier formé à partir des métaux précités. On obtient alors des nanofils 15 métalliques.

On obtient ainsi un nanogénérateur piézo-électrique 110, comme cela est représenté sur la figure 1(e).

En fonctionnement, toute action mécanique subie par le nanogénérateur piézo-électrique 110 impliquera la génération d'un courant électrique entre les deux couches 14, 16.

Un nanogénérateur piézo-électrique a été fabrique conformément au procédé détaillé sur la figure 1 et ses propriétés piézo-électriques ont été testées pour chacune des structures intermédiaires des figures 1(a) à 1(d) et finalement pour le nanogénérateur piézo-électrique lui-même de la figure 1(e).

Plus précisément, cinq membranes ont été testées.

Une première membrane (M1) correspondant à la membrane 100 (fig. 1(a)) réalisée en β-PVDF polarisé recouverte par une couche d'or sur chacune des faces principales externe 11, 12 pour pouvoir effectuer une mesure (100nm pour chaque couche d'or). La membrane est fournie par la société Piezotech.

Une deuxième membrane (M2) correspondant à la membrane 101 (fig. 1(b)) recouverte par une couche d'or sur chacune des faces principales externe 11, 12 pour pouvoir effectuer une mesure (100nm pour chaque couche d'or). La membrane 100 est fournie par la société Piezotech. L'irradiation de la membrane 100 a été effectuée à une énergie de 10MeV/uma avec des ions Kr (Kr³⁶⁺), au GANIL (Caen, FRANCE) et avec une fluence de 10⁹ ions/cm².

Une troisième membrane (M3) correspondant à la membrane 102 (fig. 1(c)) recouverte par une couche d'or sur chacune des faces principales externe 11, 12 pour pouvoir effectuer une mesure (100nm pour chaque couche d'or). La membrane 100 est fournie par la société Piezotech. L'irradiation de la membrane 100 a été effectuée à une énergie de 10MeV/uma avec des ions Kr (Kr³⁶⁺), au GANIL et avec une fluence de 10⁹ ions/cm², La révélation chimique a été réalisée par hydrolyse basique avec une solution aqueuse de KOH à 10N et KMnO₄ à 0,25N, à la température de 65°C. Cette révélation chimique a permis d'obtenir des nanopores cylindriques dans le βPVDF irradié, sur une durée permettant d'obtenir des nanopores de diamètre 70mn (cf. relation Dₙ= 1,6*t).

Une quatrième membrane (M4) correspondant au nanogénérateur piézo-électrique 110 (fig. 1(e)) recouverte par une couche d'or 14, 16 sur chacune des faces principales externe 11, 12 pour pouvoir effectuer une mesure (100nm pour chaque couche d'or). La membrane 100 est fournie par la société Piezotech. L'irradiation de la membrane 100 a été effectuée à une énergie de 10MeV/uma avec des ions Kr (Kr³⁶⁺), au GANIL et avec une fluence de 10⁹ ions/cm², La révélation chimique a été réalisée par hydrolyse basique avec une solution aqueuse de KOH à 10N et KMnO₄ à 0,25N, à la température de 65°C. Cette révélation chimique a permis de réaliser des nanopores cylindriques dans le βPVDF irradié, sur une durée permettant d'obtenir des nanopores de diamètre 70nm (cf. relation Dₙ= 1,6*t). Les nanopores ont été remplies par du nickel par électrodéposition (bain électrolytique de pH = 6,2, comportant des ions nickel).

Une cinquième membrane (M5) correspondant au nanogénérateur piézo-électrique 110 (fig. 1(e)) recouverte par une couche d'or 14, 16 sur chacune des faces principales externe 11, 12 pour pouvoir effectuer une mesure (100nm pour chaque couche d'or). La membrane 100 est fournie par la société Piezotech. L'irradiation de la membrane 100 a été effectuée à une énergie de 10MeV/uma avec des ions Kr (Kr³⁶⁺), au GANIL et avec une fluence de 10⁹ ions/cm². La révélation chimique a été réalisée par hydrolyse basique avec une solution aqueuse de KOH à 10N et KMnO₄ à 0,25N, à la température de 65°C. Cette révélation chimique a permis d'obtenir des nanopores cylindriques dans le βPVDF irradié, sur une durée permettant d'obtenir des nanopores de diamètre 70nm (cf. relation Dₙ= 1,6*t). Les nanopores ont été remplies par du cuivre par électrodéposition (bain électrolytique de pH = 6,2 comportant des ions cuivre).

Chacune de ces cinq membranes M1 à M5 a été installée au sein d'un dispositif de test DT tel que représenté sur la figure 2(a).

La membrane ME, représentant les membranes M1 à M5, est connectée, via les couches en or et des connexions électriques C1 et C2, à un oscilloscope OS. En cours de test, elle est soumise à une action mécanique répétée à une fréquence de 125 tours/mn (≅ 2,083Hz) par l'intermédiaire d'une massue MS montée sur un axe pivotant P reliée à un moteur régle à cette fréquence. La massue est agencée, par rapport à la membrane ME, pour frapper cette membrane ME sous test à cette fréquence, dans un mouvement de va-et-vient autour de son axe de rotation défini par le pivot P, ce mouvement de va-et-vient étant représenté par la flèche F, à double sens. Ce dispositif de test DT assure que la membrane subisse une action mécanique identique à chaque frappe de la massue MS.

Il a alors été possible de déterminer la tension délivrée par la membrane testée (oscilloscope) sous l'action mécanique de la massue.

Les résultats d'essais sont fournis sur la figure 2(b).

Sur cette figure 2(b), on représente la tension enregistrée aux bornes de la membrane testée en fonction du temps. La durée de chaque test a été limitée à 80mn.

La courbe M1 (membrane M1) met en évidence les propriétés piézo-électriques de la membrane commerciale.

La courbe M2 (membrane M2) montre l'effet obtenu par l'irradiation de la membrane sur les propriétés électriques. En comparant les courbes M1 et M2, on observe donc que l'irradiation améliore les propriétés piézo-électriques de la membrane, d'un facteur d'au moins trois.

L'accroissement des propriétés piézo-électriques est donc lié à la fluence des ions lourds irradiant la membrane 100. On estime ainsi qu'avec une fluence strictement inférieure à 10³ ions/cm², l'amélioration des propriétés piézo-électriques de la membrane 100 n'est pas sensible. Par ailleurs, on estime qu'avec une fluence strictement supérieure à 10¹⁰ ions/cm², les propriétés piézo-électriques de la membrane 100 sont dégradées.

La courbe M3 (membrane M3) montre l'effet obtenu lorsque l'on retire une partie de la zone de défaut générée par le passage (traces latentes) des ions lourds à travers à la membrane pour former les nanopores. Par rapport à la courbe M2, on perd en propriétés piézo-électriques. Cependant, en comparaison à la courbe M1, le gain sur les propriétés piézo-électriques reste de l'ordre de deux fois supérieur. Le fait de retirer de la matière à la membrane piézo-électrique n'a donc pas pour conséquence de diminuer ou de maintenir les propriétés piézo-electriques par rapport à la membrane M1.

Les inventeurs considèrent que ceci est lié aux zones de défauts, créées par l'irradiation et qui sont toujours autour de chacun des nanopores.

Enfin, les courbes M4 (membrane M4) et M5 (membrane M5) montrent que la formation des nanofils permet de maintenir un gain substantiel sur les propriétés piézo-électriques, par rapport à la membrane M1 et ce, quel que soit le matériau métallique utilisé pour remplir les nanopores.

On constate cependant que le gain dépend de la nature du matériau métallique considéré.

En effet, avec du Nickel, les performances sont, à l'issue du test, à peu près similaires à celles obtenues avec la membrane M3, à savoir un gain d'un facteur deux par rapport à la membrane M1. Avec du cuivre, le gain est de l'ordre de 10 à 15% seulement, par rapport à la membrane M1.

Comme cela a été précisé précédemment, les nanopores peuvent présenter une forme autre que la forme cylindrique.

Par exemple, les nanopores et par suite, les nanofils peuvent présenter une forme conique.

La forme conique est plus avantageuse sur le plan mécanique. Cela peut présenter un intérêt car le nanogénérateur piézo-électrique est destiné à être soumis, en utilisation, à des contraintes mécaniques.

On a représenté, sur les figures 3(a) à 3(e), la réalisation d'un nanogénérateur piézo-électrique présentant des nanofils 15° coniques.

Le procédé de fabrication est similaire à celui décrit à l'appui des figures 1(a) à 1(e). La différence de structure entre le nanogénérateur 110° piézo-électrique de la figure 3(e) et celui de la figure 1(e) provient de l'étape de révélation chimique, comme cela peut être observé en comparant les membranes nanostructurées 102', 102 des figures 3(c) et 1(c), respectivement La figure 3(d) qui montre la structure intermédiaire 103' est à comparer avec la structure intermédiaire 103 de la figure 1(d).

De manière générale, pour contrôler la forme des nanopores 13, 13', deux aspects importants interviennent : la nature du matériau formant la membrane 100 et les conditions de la révélation chimique, à savoir par exemple dans le cas d'une hydrolyse basique, la composition de la solution servant à cette hydrolyse basique.

Dans le cas d'une forme conique, il convient également de faire une attaque chimique par l'une seule 11 des faces principales externes 11, 12.

L'obtention d'une forme conique est plus aisée avec le copolymère P(VDF-TrFE) qu'avec le βPVDF, bien que cela soit possible avec le βPVDF en adaptant la composition de la solution employée pour l'hydrolyse basique.

On a représenté, sur les figures 4(a) à 4(e), la réalisation d'un nanogénérateur piézo-électrique présentant des nanopores 13" bi-coniques.

Le procédé de fabrication est similaire à celui décrit à l'appui des figures 1(a) à 1(e). La différence de structure entre le nanogénérateur 110" piézo-électrique de la figure 4(e) et celui de la figure 1(e) provient de l'étape de révélation chimique, comme cela peut être observé en comparant les membranes nanostructurées 102", 102 des figures 4(c) et 1(c), respectivement. La figure 3(d) qui montre la structure intermédiaire 103" est à comparer avec la structure intermédiaire 103 de la figure 1(d).

Par rapport aux figures 3(a) à 3(e), la révélation chimique s'effectue en attaquant par les deux faces 11, 12 principales externes de la membrane d'ailleurs comme cela peut être effectué lorsque l'on cherche à réaliser des nanopores cylindriques.

Au cours de la réalisation des nanofils, on peut choisir de ne remplir que certains nanopores, par exemple les nanopores débouchant sur l'une 12 des faces principales externes 11, 12 de la membrane 102". C'est d'ailleurs ce qui est illustré sur les figures annexées.

On pourrait cependant prévoir de remplir également une partie des nanopores 13''', une partie seulement pour s'assurer que les nanofils 15" ne soient pas au contact de la couche 16.

L'obtention d'une forme bi-conique est plus aisée avec le copolymère P(VDF-TrFE) qu'avec le βPVDF, bien que cela soit possible avec le βPVDF en adaptant la composition de la solution employée pour l'hydrolyse basique.

Sur le plan mécanique, il n'y a pas de différence fondamentale entre une forme conique et une forme bi-conique. Toutefois, la forme bi-conique est généralement plus aisée à fabriquer que la forme conique, dans la mesure où la révélation chimique (attaque) se fait simultanément sur les deux faces de la membrane. En conséquence, il n'y a pas de stratégie d'attaque à adopter et une simple immersion dans la membrane dans le bain permettant la révélation suffit.

Dans la description qui précède, nous avons considéré le cas où tous les nanofils étaient formés d'un même matériau, qu'il soit métallique ou semiconducteur.

Il est possible de modifier le procédé de fabrication pour obtenir un nanogénérateur piézo-electrique avec des nanofils formés par des matériaux différents.

Ce procédé reprend l'ensemble des étapes a) à f) décrites précédemment, mais comporte également des étapes additionnelles.

Plus précisément, ce procédé de fabrication met en oeuvre les étapes suivantes :
A) mettre en oeuvre les étapes a) à e), où l'étape b) est réalisée avec une fluence comprise entre 10³ ions/cm² et 5.10⁹ ions/cm², de préférence entre 10³ ions/cm² et 10⁸ ions/cm², et l'étape e) d'électrodéposition formant des nanofils 15 réalisés avec un premier matériau semiconducteur ou conducteur électdque ;
B) répéter les étapes b) et c), ce qui permet de réaliser d'autres nanopores 130, l'étape b) étant réalisée avec une fluence comprise entre 10³ ions/cm² et 5.10⁹ ions/cm², de préférence entre 10³ ions/cm² et 10⁸ ions/cm²;
C) supprimer la couche 14 en matériau conducteur de l'électricité déposée à l'étape d) ;
D) mettre en oeuvre l'étape f), si bien qu'on définit une couche 16 en matériau conducteur de l'électricité, qui n'est pas en contact avec les nanofils, sur une face externe principale de ladite membrane ;
E) répéter l'étape e) d'électrodéposition pour former des nanofils 150 dans lesdits autres nanopores 130 avec un deuxième matériau semiconducteur ou conducteur électrique, différent du premier matériau semiconducteur ou conducteur électrique ;
F) répéter l'étape d).

Ce procédé de fabrication sera appelé « double irradiation » dans la suite de la description.

Par rapport au procédé de fabrication décrit à l'appui de la figure 1, les étapes additionnelles sont les étapes B), C), E) et F). Les étapes B) et C) sont mises en oeuvre entre les étapes e) et f). Les étapes E) et F) sont mises en oeuvre après l'étape f).

Comme on peut le constater, les étapes A), B), D), E) et F) sont effectuées dans des conditions similaires à celles des étapes a) à f). En ce qui concerne l'étape C), la suppression de la couche en matériau conducteur de l'électricité déposée à l'étape d) est particulièrement aisée. En effet, à l'issue de l'étape B), la révélation chimique pèle partiellement la couche en matériau conducteur de l'électricité déposée l'étape d) et un simple nettoyage mécano-chirmque, par exemple à l'éthanol, permet de supprimer cette couche.

Afin de mieux comprendre ce procédé de fabrication, on pourra se reporter à la figure 5, laquelle comprend les figures 5(a) à 5(e). On notera que, par souci de simplification des figures annexées, les traces latentes TL du passage des ions lourds à travers la membrane et les zones défaut ZD restantes après la révélation chimique ne sont pas représentées sur ces figures, contrairement aux figures 1, 3 et 4.

On a représenté sur la figure 5(a), la membrane obtenue à l'issue de l'étape A). Cette membrane correspond donc à celle qui est représentée sur la figure 1(d).

On a représenté sur la figure 5(b), la membrane obtenue à l'issue de l'étape B).

On a représenté sur la figure 5(c), la membrane obtenue à l'issue de l'étape D).

On a représenté sur la figure 5(d), la membrane obtenue à l'issue de l'étape E).

Enfin, on a représenté sur la figure 5(e), le nanogénérateur piézo-électrique 110''' finalement obtenu après la mise en oeuvre de l'étape F).

Ce procédé de fabrication présente un intérêt particulier lorsque l'on souhaite déposer des nanofils présentant des propriétés photovoltaïques (par exemple ZnO, au cours de l'étape A)) et des nanofils présentant des propriétés thermoélectriques (par exemple Bi₂Te₃ ou Sb₂Te₃, au cours de l'étape E)).

Bien entendu, on pourrait prévoir de déposer les mêmes matériaux aux étapes A) et E), Mais cela présente un intérêt limité car, dans ce cas, le procédé de fabrication mis en oeuvre selon les étapes a) à e) est plus rapide.

Il est également possible de proposer un autre procédé de fabrication pour obtenir un nanogénérateur piézo-électrique avec des nanofils formés par des matériaux différents et procurant donc les mêmes avantages.

Plus précisément, cet autre procédé de fabrication d'un nanogénérateur piézo-électrique met en oeuvre les étapes suivantes :
A') mettre en oeuvre les étapes a) à d), l'étape a) étant réalisée avec une première membrane dite membrane source MSO ;
B') mettre en oeuvre les étapes a) à c), l'étape a) étant réalisée avec une autre membrane dite membrane objet MOB ;
C') disposer la membrane objet obtenue à l'issue de l'étape B') sur la membrane source obtenue à l'issue de l'étape A') ;
D') mettre en oeuvre l'étape e), cette étape d'électrodéposition permettait de remplir partiellement chacun des nanopores 13 formé par l'association d'au moins un nanopore de la membrane objet obtenue à l'issue de l'étape B'), lequel nanopore se superpose à an moins un nanopore de la membrane source obtenue à l'issue de l'étape A') pour former des nanofils 15 réalisés avec un premier matériau semiconducteur ou conducteur électrique, les autres nanopores 130 n'étant pas remplis ;
E') séparer les deux membranes l'une de l'autre ;
F') mettre en oeuvre l'étape f) sur la membrane objet obtenue à l'issue de l'étape E') si bien qu'on définit une couche 16 conductrice de l'électricité, qui n'est pas en contact avec les nanofils, sur une face externe principale de ladite membrane;
G') mettre en oeuvre l'étape e) d'électrodéposition sur la membrane Objet obtenue à l'issue de l'étape F') pour former des nanofils 150 dans lesdits autres nanopores 130 avec un deuxième matériau semiconducteur ou conducteur électrique, différent du premier matériau semiconducteur ou conducteur électrique ;
H') mettre en oeuvre l'étape d) sur la membrane objet obtenue à l'issue de l'étape G').

Comme on peut le constater, la membrane source n'est mise en oeuvre que pour servir de « masque » au cours de l'étape D'). En effet, les nanopores de la membrane objet qui ne communiquent pas avec les nanopores de la membrane source à l'issue de l'étape C') ne peuvent pas être remplies par électrodéposition car ces nanopores de la membrane objet ne voient pas la couche de la membrane source, obtenue à l'issue de l'étape B') (étape c)) qui sert d'électrode de référence pour réaliser l'électrodéposition, Une fois les deux membranes séparées, la membrane source n'intervient plus dans le procédé de fabrication.

C'est pourquoi, cette variante sera nommée, procédé de fabrication par « masquage » dans la suite de la description.

Afin de mieux comprendre ce procédé de fabrication, on pourra se reporter à la figure 6, laquelle comprend les figures 6(a) à 6(e). On notera que, par souci de simplification des figures annexées, les traces latentes TL du passage des ions lourds à travers la membrane et les zones défaut ZD restantes après la révélation chimique ne sont pas représentées sur ces figures, contrairement aux figures 1, 3 et 4.

On a représenté sur la figure 6(a), l'association des deux membranes, membrane source servant de « masque » sur laquelle se situe la membrane objet qui va permettre d'obtenir le nanogénérateur piézo-électrique, obtenue à l'issue de l'étape C'),

On a représenté sur la figure 6(b), la membrane obtenue à l'issue de l'étape D').

On a représenté sur la figure 6(c), la membrane objet obtenue à l'issue de l'étape F'). Il convient de noter que la membrane représentée sur cette figure 6(c) est similaire à celle qui est représentée sur la figure 5(c).

On a représenté sur la figure 6(d), la membrane objet obtenue à l'issue de l'étape G'). Il convient de noter que la membrane représentée sur cette figure 6(d) est similaire à celle qui est représentée sur la figure 5(d).

Enfin, on a représenté sur la figure 6(e), le nanogénérateur piézo-électrique 110'''' finalement obtenu après fa mise en oeuvre de l'étape H'). Ce nanogénérateur piézo-électrique 110'''' est similaire à celui qui est représenté sur la figure 5(e).

Quel que soit le procédé de fabrication d'un nanogénérateur piézo-électrique tel que décrit précédemment, on peut envisager, après avoir obtenu ce nanogénérateur piézo-électrique, à savoir à l'issue de l'étape f), F), ou H') selon le procédé de fabrication considéré, de réaliser une irradiation supplémentaire dans les conditions de l'étape b). Dans ce cas, il convient toutefois de s'assurer, avant d'engager une telle irradiation, que la membrane ne sera finalement pas soumise, compte tenu de l'irradiation effectuée à l'étape b) et à cette irradiation supplémentaire à une irradiation aux ions lourds avec une fluence strictement supérieure à 10¹⁰ ions/cm². Par exemple, si au cours de l'étape b), la fluence était de 10⁹ ions/cm², on peut tout à fait réaliser une irradiation supplémentaire avec une fluence identique. En pratique, on envisagera une irradiation supplémentaire aux ions lourds avec une fluence de comprise entre 10⁷ ions/cm² et 10⁸ ions/cm².

L'invention concerne également un nanogénérateur piézo-électrique susceptible d'être obtenu par le procédé de fabrication selon l'invention, quelle que soit la variante considérée (figures 1, 3, 4, 5 ou 6). En particulier, on notera que la fluence des ions lourds impliquera une densité surfacique de nanopores correspondante, à savoir dans sa plus grande généralité comprise entre 10³ entre 10¹⁰ nanofils/cm².

Plus précisément, l'invention propose un nanogénérateur piézo-électrique 110, 110', 110", 110''', 110'''' comprenant :
- une membrane 100 en β-PVDF polarisé ou en copolymère PVDF-TrFe polarisé présentant donc des propriétés piézo-électriques, ladite membrane 100 présentant par ailleurs deux faces externes principales 11, 12 séparées par une épaisseur e de membrane ;
- une première couche 14 réalisée en un matériau conducteur électrique recouvrant l'une 11 des deux faces externes principales de la membrane 100 ;
- une deuxième couche 16 réalisée en un matériau conducteur électrique recouvrant l'autre 12 des deux faces principales externes de la membrane 100 ;
ladite membrane 100 étant, dans son épaisseur, nanostructurée par au moins un ensemble de nanofils 15, 15', 15" semiconducteurs ou conducteurs électriques, par exemple métalliques, avec une densité surfacique comprise entre 10³ nanofils/cm² et 10¹⁰ nanofils/cm², lesdits nanofils 15, 15', 15" étant connectés à la première couche 14 mais pas à la deuxième couche 16, et ladite membrane comportant, autour des nanofils 15, 15', 15" des zones de défaut ZD laissées par le passage d'ions lourds à travers toute l'épaisseur de cette membrane 100 pour créer des nanopores accueillant lesdits nanofils.

De ce fait, ce nanogénérateur piézo-électrique 110, 110', 110", 110''', 110'''' présente des propriétés piézoélectriques accrues par rapport à un nanogénérateur piézo-électrique non irradié.

Le nanogénérateur piézo-électrique 110, 110', 110", 110''', 110'''' pourra également être tel que la membrane 100 est, dans son épaisseur, nanostructurée par :
- un premier ensemble de nanofils 15, 15', 15" semiconducteurs ou conducteurs électriques, par exemple métalliques, selon une densité surfacique comprise entre 10³ nanofils/cm² et 5.10⁹ nanofils/cm², lesdits nanofils 15, 15', 15" étant connectés à la première couche 14 mais pas à la deuxième couche 16,
- un deuxième ensemble de nanofils 150 semiconducteurs ou conducteurs électriques, par exemple métalliques, selon une densité surfacique comprise entre 10³ nanofils/cm² et 5.10⁹ nanofils/cm², lesdits nanofils 150 de ce deuxiéme ensemble de nanofils 150 étant connectés à la deuxième couche 16 mais pas à la première couche 14,
ladite membrane 100 comportant, autour des nanofils 15, 15', 15", 150, des zones de défaut ZD laissées par le passage des ions lourds à travers toute l'épaisseur de cette membrane 100 pour créer des nanopores accueillant lesdits nanofils 15, 15', 15", 150 des deux ensembles de nanofils 15, 15', 15", 150.

Dans ce cas, on mettra en oeuvre avantageusement les procédés décrits à l'appui des figures 5 (« double irradiation ») et 6 (« masquage »).

Les nanofils 15, 15', 15", 150 de ce nanogénérateur piezo-électrique pourront être cylindriques et/οu coniques.

Lorsque les nanofils 15, 15', 15", 150 sont cylindriques, ils pourront présenter un diamètre compris entre 20nm et 110nm.

La densité surfacique des nanofils 15, 15', 15", 150 du ou de chaque ensemble de nanofils est comprise entre 10³ nanofils/cm² et 10⁹ nanofils/cm², par exemple entre 10⁶ nanofils/cm² et 10⁹ nanofils/cm².

L'épaisseur e de la membrane 100 pourra être comprise entre 1µm et 60µm, par exemple de l'ordre de 10µm, en particulier 10µm pour du β-PVDF et 11µm pour le copolymère P(VDF-TrFE).

En revanche, il n'y a *a priori* pas de limitation sur la largeur et la longueur de la membrane et par suite du nanogénérateur piézo-électrique selon l'invention. Le terme « nano » dans « nanogénérateur » provient de la dimension des pores.

L'invention concerne également un dispositif 400 comprenant :
- un nanogénérateur 110, 110', 110", 110''' piézo-électrique conforme à l'invention ;
- un condensateur 200 ;
- un moyen 300, disposé entre le nanogénérateur piézo-électrique et le condensateur 200, pour transférer le courant sortant du nanogénérateur 110, 110', 110", 110''' piézo-électrique vers le condensateur 200 sans possibilité de retour vers le nanogénérateur piézo-électrique.

Le moyen 300 peut être un pont de Graetz, plus généralement encore appelé pont de diodes.

Le dispositif 400 est représenté sur la figure 7.

Avantageusement, le condensateur 200 présentera une conception particulière, à savoir une conception à base d'une membrane isolante électriquement et nanostructurée, comme cela est représenté sur la figure 8, pour ainsi former un nanocondensateur.

Plus précisément, le nanocondensateur 200 pourra comprendre :
- une membrane 210, réalisée en un matériau isolant électrique, présentant deux faces externes principales 211, 212 séparées par une épaisseur de membrane;
- une première couche 214 réalisée en un matériau conducteur électrique recouvrant l'une 212 des deux faces externes de la membrane 210 ;
- une deuxième couche 216 réalisée en un matériau conducteur électrique recouvrant l'autre 211 des deux faces externes principales de la membrane 210;
ladite membrane 210 étant, dans son épaisseur, nanostructurée d'une part, par un premier ensemble de nanofils 15 semiconducteurs ou conducteurs de l'électricité, par exemple métalliques, connectés à la première couche 214 conductrice de l'électricité mais pas à la deuxième couche 216 conductrice de l'électricité et d'autre part, par un deuxième ensemble de nanofils 150 (représentés avec des hachures sur la figure 8) semiconducteurs ou conducteurs de l'électricité, par exemple métalliques, connectés à la deuxième couche 216 conductrice de l'électricité mais pas à la première couche 214 conductrice de l'électricité, lesdits nanofils 15, 150 du premier ensemble de nanofils et du deuxième ensemble de nanofils étant interdigités.

Dans sa structure, le nanocondensateur 200 est similaire au nanogénérateur piézo-électrique représenté sur la figure 5(e) ou 6(e), sauf que la membrane mise en oeuvre au cours de l'étape a) est isolante électriquement.

La membrane du nanocondensateur 200 pourra être réalisée en un matériau choisi parmi : le polycarbonate (PC), l'alumine (Al₂O₃), le polyéthylènetérephtalate (PET) ou le polyimide (PI), avantageusement du Kapton®.

Le nanocondensateur 200 peut donc être obtenu avec le procédé de fabrication nommé « double irradiation », en mettant donc en ceuvre des étapes A) à F).

En variante, le nanocondensateur 200 peut également être obtenu par le procédé de fabrication nommé « masquage », en mettant donc en oeuvre les étapes A') à H').

Toutefois, pour réaliser le nanocondensateur 200, que ce soit par « double irradiation » ou « masquage », il n'est pas obligatoire, au cours de la fabrication, de mettre en oeuvre une fluence des ions lourds dans la gamme allant de 10³ ions/cm² et 10¹⁰ ions/cm², ni d'ailleurs de contrôler la révélation chimique pour maintenir des zones de défauts des traces latentes laissées, dans la membrane, par l'irradiation aux ions lourds. En effet, la membrane du nanocondensateur étant isolante électriquement, on ne cherche nullement à modifier des propriétés piézo-électriques. En conséquence, il n'est pas non plus obligatoire de prévoir des nanofils réalisés dans deux matériaux différents.

Le nanocondensateur 200 ainsi obtenu présente une capacité surfacique très importante, liée à la présence de nanofils interdigités. En effet, les inventeurs ont pu observer que cette interdigitation des nanofils permettait d'augmenter sensiblement la capacité du nanocondensateur.

L'intergiditation provient du fait que les nanofils du premier ensemble de nanofils semiconducteurs ou conducteurs électriques connectés à la première couche conductrice de l'électricité mais pas à la deuxième couche conductrice de l'électricité et les nanofils du deuxième ensemble de nanofils semiconducteurs ou conducteurs électriques connectés à la deuxième couche conductrice de l'électricité mais pas à la première couche conductrice de l'électricité, sont disposés en regard les uns des autres,

Dit autrement, le nanocondensateur 200 n'est pas formé d'un premier ensemble de nanofils situé d'un côté, par exemple gauche, du nanocondensateur et d'un deuxième ensemble de nanofils situé de l'autre côté, par exemple droit, du nanocondensateur (= non interdigité).

A cet égard, les nanofils formant les deux ensembles de nanofils du nanocondensateur 200 peuvent être les mêmes ou différents.

Les nanofils métalliques de l'un quelconque du premier et du deuxième ensemble de nanofils pourront être choisis parmi : Au, Zn, Cu, Co, Ni, Ag, Pt ou un alliage métallique, en particulier réalisé à partir des métaux précités.

On notera que, en ce qui concerne le nanogénératear piézo-électrique 110''', 110'''' représenté sur les figures 5(e) et 6(e), l'interdigidation n'est pas obligatoire. Pour les besoins de la description, nous avons cependant représentés des nanogénérateurs piézoélectrique pour lesquels il y a une interdigitation.

Enfin, il convient de noter que l'invention pourrait également concerner un procédé de fabrication d'un nanocondensateur, soit de type « double irradiation » (figure 5), soit de type « masquage » (figure 6) ainsi qu'un ici nanocondensateur.

Ainsi, l'invention pourrait concerne un procédé de fabrication d'un nanocondensateur, comportant les étapes A") à F") suivantes :
A") mettre en oeuvre les sous étapes suivantes :
   a") fournir une membrane en matériau isolant électrique, ladite membrane présentant par ailleurs deux faces externes principales 11, 12 séparées par une épaisseur e de membrane ;
   b") irradier ladite membrane par l'une au moins de ses deux faces externes principales (11, 12) à travers toute l'épaisseur de ladite membrane avec des ions lourds, en conséquence de quoi on obtient une membrane avec des traces latentes du passage des ions lourds à travers toute l'épaisseur de celle-ci ;
   c") réaliser une révélation chimique des traces latentes sur une durée prédéterminée pour maintenir une zone de défaut appartenant à la trace latente, en conséquence de quoi on obtient une membrane nanostructurée avec des nanopores comportant, autour de chaque nanopore, une zone de défaut ;
   d") déposer une couche 14 d'un matériau conducteur de l'électricité sur l'une 12 des deux faces externes principales 11, 12 de ladite membrane ;
   e") réaliser une électrodéposition d'un matériau semi-conducteur ou conducteur de l'électricité dans les nanopores en arrêtant l'électrodéposition avant le remplissage complet des nanopores, en conséquence de quoi on obtient une membrane 103 nanostructurée avec des nanofils 15 remplissant partiellement les nanopores ;
B") répéter les sous-étapes b") et c"), ce qui permet de réaliser d'autres nanopores 130 ;
C") supprimer la couche 14 en matériau conducteur de l'électricité déposée à l'étape d") ;
D") déposer une couche d'un matériau conducteur de l'électricité sur l'autre 11 des deux faces externes principales 11, 12, si bien qu'on définit une couche 16 en matériau conducteur de l'électricité, qui n'est pas en contact avec les nanofils 15, sur une face externe principale de ladite membrane ;
E") répéter l'étape e") d'électrodéposition pour former d'autres nanofils 150 dans lesdits autres nanopores 130 ;
F") répéter l'étape d").

En variante, l'invention pourrait concerner un procédé de fabrication d'un nanocondensateur, comportant les étapes A''') à H''') suivantes :
A''') mettre en oeuvre les sous-étapes suivantes :
   a''') fournir une première membrane en matériau isolant électrique, dite membrane source MSO, ladite membrane source MSO présentant par ailleurs deux faces externes principales 11, 12 séparées par une épaisseur e₁ de membrane ;
   b''') irradier ladite membrane source MSO par l'une au moins de ses deux faces externes principales à travers toute l'épaisseur de ladite membrane source avec des ions lourds, en conséquence de quoi on obtient une membrane source MSO avec des traces latentes du passage des ions lourds à travers toute l'épaisseur de celle-ci ;
   c''') réaliser une révélation chimique des traces latentes, en conséquence de quoi on obtient une membrane nanostructurée ;
   d''') déposer une couche 14 d'un matériau conducteur de l'électricité sur l'une 12 des deux faces externes principales 11, 12 de ladite membrane ;
B''') mettre en oeuvre les étapes a''') à c'''), l'étape a''') étant réalisée avec une autre membrane dite membrane objet MOB ;
C''') disposer la membrane objet obtenue à l'issue de l'étape B''') sur la membrane source obtenue à l'issue de l'étape A''') ;
D''') mettre en oeuvre l'étape e'''), cette étape d'électrodéposition permettant de remplir partiellement chacun des nanopores 13 formé par l'association d'au moins un nanopore de la membrane objet obtenue à l'issue de l'étape B'''), lequel nanopore se superpose à au moins un nanopore de la membrane source obtenue à l'issue de l'étape A''') pour former des nanofils 15 réalisés avec un premier matériau semiconducteur ou conducteur électrique, les autres nanopores 130 n'étant pas remplis ;
E''') séparer les deux membranes l'une de l'autre ;
F''') déposer une couche 16 d'un matériau conducteur de l'électricité sur l'autre 11 des deux faces externes principales 11, 12 de la membrane objet obtenue à l'issue de l'étape E''') si bien qu'on définit une couche conductrice de l'électricité, qui n'est pas en contact avec les nanofils 15 ;
G''') mettre en oeuvre l'étape e''') d'électrodéposition sur la membrane objet obtenue à l'issue de l'étape F''') pour former des nanofils 150 dans lesdits autres nanopores 130 ;
H''') mettre en oeuvre l'étape d''') sur la membrane objet obtenue à l'issue de l'étape G''').

Quant au nanocondensateur 200 susceptible d'être obtenu par l'un quelconque des procédés à « double irradiation » ou à « masquage », il s'agira d'un nanocondensateur 200 comportant :
- une membrane 210, réalisée en un matériau isolant électrique, présentant deux faces externes principales 211, 212 séparées par une épaisseur de membrane ;
- une première couche 214 réalisée en un matériau conducteur électrique recouvrant l'une 211 des deux faces externes principales de la membrane ;
- une deuxième couche 216 réalisée en un matériau conducteur électrique recouvrant l'autre 212 des deux faces externes de la membrane ;
ladite membrane étant, dans son épaisseur, nanostructurée d'une part, par un premier ensemble de nanofils 15 semiconducteurs ou conducteurs électriques, par exemple métalliques, connectés à la première couche conductrice de l'électricité mais pas à la deuxième couche conductrice de l'électricité et d'autre part, par un deuxième ensemble de nanofils 150 semiconducteurs ou conducteurs électriques, par exemple métalliques, connectés à la deuxième couche conductrice de l'électricité mais pas à la première couche conductrice de l'électricité, lesdits nanofils du premier ensemble de nanofils et du deuxième ensemble de nanofils étant interdigités.

La membrane 210 isolante électrique du nanocondensateur pourra réalisée en un matériau choisi parmi : le polycarbonate (PC), l'alumine (Al₂O₃), le polyéthylènetérephtalate (PET) ou le polyimide (PI), avantageusement du Kapton®.

Les nanofils de l'un quelconque du premier et du deuxième ensemble de nanofils pourront notamment être des nanofils métalliques choisis parmi : Au, Zn, Cu, Co, Ni, Ag, Pt ou un alliage métallique, en particulier réalisé à partir des métaux précités.

## Revendications

1. Procédé de fabrication d'un nanogénérateur piézo-électrique (110, 110', 110", 110''', 110''''), **caractérisé en ce qu'**il comprend les étapes suivantes :
a) Fournir une membrane (100) en β-PVDF polarisé ou en copolymère PVDF-TrFe polarisé présentant donc des propriétés piézo-électriques, ladite membrane (100) présentant par ailleurs deux faces externes principales (11, 12) séparées par une épaisseur (e) de membrane ;
b) irradier ladite membrane (100) par l'une au moins de ses deux faces externes principales (11, 12) à travers toute l'épaisseur de ladite membrane avec des ions lourds présentant une fluence comprise entre 10³ ions/cm² et 10¹⁰ ions/cm², en conséquence de quoi on obtient une membrane (101) avec des traces latentes (TL) du passage des ions lourds à travers toute l'épaisseur de celle-ci ;
c) réaliser une révélation chimique des traces latentes (TL) sur une durée prédéterminée pour maintenir une zone de défaut (ZD) appartenant à la trace latente, en conséquence de quoi on obtient une membrane nanostructurée (102, 102', 102") avec des nanopores (13, 13', 13") comportant, autour de chaque nanopore (13, 13', 13"), une zone de défaut (ZD) ;
d) déposer une couche d'un matériau conducteur de l'électricité sur l'une (12) des deux faces externes principales (11, 12) de ladite membrane (102, 102', 102") ;
e) réaliser une électrodéposition d'un matériau semi-conducteur ou conducteur de l'électricité dans les nanopores (13, 13', 13") en arrêtant l'électrodéposition avant le remplissage complet des nanopores (13, 13', 13"), en conséquence de quoi on obtient une membrane nanostructurée (103, 103', 103") avec des nanofils (15, 15', 15") remplissant partiellement les nanopores (13, 13', 13") ; et
f) déposer une couche d'un matériau conducteur de l'électricité sur l'autre (11) des deux faces externes principales (11, 12), qui n'est donc pas en contact avec les nanofils.

2. Procédé selon la revendication 1, dans lequel pour irradier, pendant l'étape b), ladite membrane à travers toute l'épaisseur de celle-ci, les ions lourds présentent une énergie comprise entre 2MeV/uma et 15MeV/uma.

3. Procédé selon l'une des revendications précédentes, dans lequel l'étape b) d'irradiation s'effectue avec des ions lourds de type Kr ou Xe.

4. Procédé selon l'une des revendications précédentes, dans lequel l'étape b) d'irradiation s'effectue avec des ions lourds dont la fluence est comprise entre 10³ ions/cm² et 10⁹ ions/cm², par exemple entre 10⁶ ions/cm² et 10⁹ ions/cm².

5. Procédé selon l'une des revendications précédentes, dans lequel l'étape b) d'irradiation s'effectue sous atmosphère inerte, par exemple sous hélium.

6. Procédé selon l'une des revendications précédentes, dans lequel l'étape c) de révélation chimique est réalisée par hydrolyse basique avec une solution aqueuse de KOH à 10N et KMnO₄ à 0,25N, à une température comprise entre 40°C et 75°C, par exemple entre 40°C et 70°C, et 70°C, et de préférence à 65°C.

7. Procédé selon l'une des revendications précédentes, comportant les étapes suivantes :
A) mettre en oeuvre les étapes a) à e), où l'étape b) est réalisée avec une fluence comprise entre 10³ ions/cm² et 5.10⁹ ions/cm², de préférence entre 10³ ions/cm² et 10⁸ ions/cm², et l'étape e) d'éleetrodéposition formant des nanofils (15) étant réalisés avec un premier matériau semiconducteur ou conducteur électrique ;
B) E") répéter les étapes b) et c), ce qui permet de réaliser d'autres nanopores (130), l'étape b) étant réalisée avec une fluence comprise entre 10³ ions/cm² et 5.10⁹ ions/cm², de préférence entre 10³ ions/cm² et 10⁸ ions/cm² ;
C) supprimer la couche (14) en matériau conducteur de l'électricité déposée à l'étape d) ;
D) mettre en oeuvre l'étape f), si bien qu'on définit une couche (16) en matériau conducteur de l'électricité, qui n'est pas en contact avec les nanofils (15, 15', 15"), sur une face externe principale de ladite membrane ;
E) répéter l'étape e) d'électrodéposition pour former d'autres nanofils (150) dans lesdits autres nanopores (130) avec un deuxième matériau semiconducteur ou conducteur électrique, différent du premier matériau semiconducteur ou conducteur électrique ;
F) répéter l'étape d).

8. Procédé selon l'une des revendications 1 à 6, comportant les étapes suivantes :
A') mettre en oeuvre les étapes a) à d), l'étape a) étant réalisée avec une première membrane dite membrane source (MSO) ;
B') mettre en oeuvre les étapes a) à c), l'étape a) étant réalisée avec une autre membrane dite membrane objet (MOB) ;
C') disposer la membrane objet obtenue à l'issue de l'étape B') sur la membrane source obtenue à l'issue de l'étape A') ;
D') mettre en oeuvre l'étape e), cette étape d'électrodéposition permettant de remplir partiellement chacun des nanopores (13) formé par l'association d'au moins un nanopore de la membrane objet obtenue à l'issue de l'étape B'), lequel nanopore se superpose à au moins un nanopore de la membrane source obtenue à l'issue de l'étape A') pour former des nanofils (15) réalisés avec un premier matériau semiconducteur ou conducteur électrique, les autres nanopores (130) n'étant pas remplis ;
E') séparer les deux membranes l'une de l'autre ;
F') mettre en oeuvre l'étape f) sur la membrane objet obtenue à l'issue de l'étape E') si bien qu'on définit une couche conductrice de l'électricité, qui n'est pas en contact avec les nanofils (15), sur une face externe principale de ladite membrane ;
G') mettre en oeuvre l'étape e) d'électrodeposition sur la membrane objet obtenue à l'issue de l'étape F') pour former des nanofils (150) dans lesdits autres nanopores (130) avec un deuxième matériau semiconducteur ou conducteur électrique, différent du premier matériau semicoaducteur ou conducteur électrique ;
H') mettre en oeuvre l'étape d) sur la membrane objet obtenue à l'issue de l'étape G').

9. Procédé selon l'une des revendications 7 ou 8, dans lequel :
- le premier matériau formant des nanofils (15) est un matériau semiconducteur présentant des propriétés photovoltaïques ;
- le deuxième matériau formant les autres nanofils (150) est un matériau semiconducteur présentant des propriétés thermoélectriques.

10. Nanogénérateur piézo-électrique (110, 110', 110", 110'", 110""), **caractérisé en ce qu'**il comprend :
- une membrane (100) en β-PVDF polarisé ou en copolymère PVDF-TrFe polarisé présentant donc des propriétés piézo-électriques, ladite membrane (100) présentant par ailleurs deux faces externes principales (11, 12) séparées par une épaisseur e de membrane ;
- une première couche (14) réalisée en un matériau conducteur électrique recouvrant l'une (11) des deux faces externes principales de la membrane (100) ;
- une deuxième couche (16) réalisée en un matériau conducteur électrique recouvrant l'autre (12) des deux faces principales externes de la membrane (100) ;
ladite membrane (100) étant, dans son épaisseur, nanostructurée par au moins un ensemble de nanofils (15, 15', 15") semiconducteurs ou conducteurs électriques, par exemple métalliques, selon une densité surfacique comprise entre 10³ nanofils/cm² et 10¹⁰ nanofils/cm², lesdits nanofils (15, 15', 15") étant connectés à la première couche (14) mais pas à la deuxième couche (16), et
ladite membrane (100) comportant, autour des nanofils (15, 15', 15"), des zones de défaut (ZD) laissées par le passage des ions lourds à travers toute l'épaisseur de cette membrane (100) pour créer des nanopores accueillant lesdits nanofils (15).

11. Nanogénérateur piézo-électrique selon la revendication précédente, dans lequel la membrane (100) est, dans son épaisseur, nanostructurée par :
- un premier ensemble de nanofils (15, 15', 15") semiconducteurs ou conducteurs électriques, par exemple métalliques, selon une densité surfacique comprise entre 10³ nanofils/cm² et 5,10⁹ nanofils/cm², lesdits nanofils (15, 15', 15") étant connectés à la première couche (14) mais pas à la deuxième couche (16),
- un deuxième ensemble de nanofils (150) semiconducteurs ou conducteurs électriques, par exemple métalliques, selon une densité surfacique comprise entre 10³ nanofils/cm² et 5.10⁹ nanofils/cm², lesdits nanofils (150) de ce deuxième ensemble de nanofils (150) étant connectés à la deuxième couche (16) mais pas à la première couche (14),
ladite membrane (100) comportant, autour des nanofils (15, 15', 15", 150), des zones de défaut (ZD) laissées par le passage des ions lourds à travers toute l'épaisseur de cette membrane (100) pour créer des nanopores accueillant lesdits nanofils (15, 15', 15", 150) des deux ensembles de nanofils (15, 15', 15", 150),

12. Nanogénérateur piézo-électrique selon l'une des revendications 10 ou 11, dans lequel les nanofils du ou de l'un au moins des ensembles de nanofils (15, 15', 15", 150) est réalisé un matériau conducteur de l'électricité de type métallique, par exemple Au, Zn, Cu, Co, Ni, Ag ou Pt ou un alliage métallique, par exemple formé avec les métaux précités,

13. Nanogénérateur piézo-électrique selon l'une des revendications 10 à 12, dans lequel les nanofils du ou de l'un au moins des ensembles de nanofils (15, 15', 15", 150) est réalisé en un matériau semiconducteur présentant des propriétés photo voltaïques, par exemple le ZnO, ou thermoélectriques, par exemple le Bi₂Te₃ ou le Sb₂Te₃.

14. Nanogénérateur piézo-électrique selon l'une des revendications 10 à 13, dans lequel les nanofils (15, 15', 15", 150) sont cylindriques et/ou coniques.

15. Nanogénérateur piézo-électrique selon la revendication précédente, dans lequel les nanofils (15, 15', 15", 150), cylindriques, présentent un diamètre compris entre 20nm et 110nm.

16. Nanogénérateur piézo-électrique selon l'une des revendications 10 à 15, dans lequel la densité surfacique des nanofils (15, 15', 15", 150) du ou de chaque ensemble de nanofils est comprise entre 10³ nanofils/cm² et 10⁹ nanofils/cm², par exemple entre 10⁶ nanofils/cm² et 10⁹ nanofils/cm².

17. Nanogénérateur piézo-électrique selon l'une des revendications 10 à 16, dans lequel l'épaisseur e de la membrane (100) pourra être comprise entre 1µm et 60µm, par exemple de l'ordre de 10µm, en particulier 10µm pour du β-PVDF et 11µm pour du copolymère P(VDF-TrFE).

18. Dispositif (400) **caractérisé en ce qu'**il comprend :
- un nanogénérateur piézo-électrique (110, 110', 110", 110"') selon l'une des revendications 10 à 17 ;
- un condensateur (200) ;
- un moyen (300), disposé entre le nanogénérateur piézo-électrique et le condensateur, pour transférer le courant sortant du nanogénérateur piézo-électrique vers le condensateur sans possibilité de retour vers le nanogénérateur piézo-électiique, par exemple un pont de Graetz.

19. Dispositif selon la revendication précédente, dans lequel le condensateur (200) est un nanocondensateur comportant :
- une membrane (210), réalisée eu un matériau isolant électrique, présentant deux faces externes principales (211, 212) séparées par une épaisseur de membrane ;
- une première couche (214) réalisée en un matériau conducteur électrique recouvrant l'une (211) des deux faces externes principales de la membrane ;
- une deuxième couche (216) réalisée en un matériau conducteur électrique recouvrant l'autre (212) des deux faces externes principales de la membrane ;
ladite membrane étant, dans son épaisseur, nanostructurée d'une part, par un premier ensemble de nanofils semiconducteurs ou conducteurs électriques, par exemple métalliques, connectés à la première couche (214) conductrice de l'électricité mais pas à la deuxième couche (216) conductrice de l'électricité et d'autre part, par un deuxième ensemble de nanofils semiconducteurs ou conducteurs électriques, par exemple métalliques, connectés à la deuxième couche (216) conductrice de l'électricité mais pas à la première couche (214) conductrice de l'électricité, lesdits nanofils du premier ensemble de nanofils et du deuxième ensemble de nanofils étant interdigités.

20. Dispositif selon la revendication précédente, dans lequel la membrane du nanocondensateur est réalisée en un matériau choisi parmi : le polycarbonate (PC), l'alumine (Al₂O₃), le polyéthylénetérephtalate (PET) ou le polyimide (PI), avantageusement du Kapton®.

21. Dispositif selon l'une des revendications 19 ou 20, dans lequel les nanofils de l'un quelconque du premier et du deuxième ensemble de nanofils sont des nanofils métalliques choisis parmi : Au, Zn, Cu, Co, Ni, Ag, Pt ou un alliage métallique, en particulier réalisé à partir des métaux précités.

## Patentansprüche

1. Verfahren zur Herstellung eines piezoelektrischen Nanogenerators (110, 110', 110", 110"', 110""), **dadurch gekennzeichnet, dass** es die folgenden Schritte umfasst:
a) Bereitstellen einer Membran (100) aus polarisiertem β-PVDF oder aus polarisiertem PVDF-TrFe-Copolymer, die folglich piezoelektrische Eigenschaften aufweist, wobei die Membran (100) außerdem zwei äußere Hauptflächen (11, 12) aufweist, die durch eine Dicke (e) einer Membran getrennt sind;
b) Bestrahlen der Membran (100) durch die mindestens eine ihrer beiden äußeren Hauptflächen (11, 12) durch die ganze Dicke der Membran hindurch mit Schwerionen, die eine Fluenz zwischen 10³ Ionen/cm² und 10¹⁰ Ionen/cm² aufweisen, in dessen Folge eine Membran (101) mit latenten Spuren (TL) des Durchgangs der Schwerionen durch die ganze Dicke davon hindurch erhalten wird;
c) Durchführen einer chemischen Entwicklung der latenten Spuren (TL) über eine vorbestimmte Dauer, um einen Fehlerbereich (ZD) aufrechtzuerhalten, der zur latenten Spur gehört, in dessen Folge eine nanostrukturierte Membran (102, 102', 102") mit Nanoporen (13, 13', 13") erhalten wird, die um jede Nanopore (13, 13', 13") herum eine Fehlerzone (ZD) einschließt;
d) Aufbringen einer Schicht eines elektrisch leitenden Materials auf eine (12) der zwei äußeren Hauptflächen (11, 12) der Membran (102, 102', 102");
e) Realisieren eines Elektroplattierens eines elektrisch halbleitenden oder leitenden Materials in den Nanoporen (13, 13', 13"), wobei das Elektroplattieren vor der vollständigen Füllung der Nanoporen (13, 13', 13") angehalten wird, in dessen Folge eine nanostrukturierte Membran (103, 103', 103") mit Nanodrähten (15, 15', 15") erhalten wird, die die Nanoporen (13, 13', 13") teilweise füllen; und
f) Aufbringen einer Schicht eines elektrisch leitenden Materials auf die weitere (11) der zwei äußeren Hauptflächen (11, 12), die folglich nicht in Kontakt mit den Nanodrähten ist.

2. Verfahren nach Anspruch 1, wobei, um die Membran während des Schrittes b) durch die ganze Dicke dieser hindurch zu bestrahlen, die Schwerionen eine Energie zwischen 2 MeV/amu und 15 MeV/amu aufweisen.

3. Verfahren nach einem der vorstehenden Ansprüche, wobei der Schritt b) einer Bestrahlung mit Schwerionen des Typs Kr oder Xe durchgeführt wird.

4. Verfahren nach einem der vorstehenden Ansprüche, wobei der Schritt b) einer Bestrahlung mit Schwerionen durchgeführt wird, deren Fluenz zwischen 10³ Ionen/cm² und 10⁹ Ionen/cm² ist, zum Beispiel zwischen 10⁶ Ionen/cm² und 10⁹ Ionen/cm².

5. Verfahren nach einem der vorstehenden Ansprüche, wobei der Schritt b) einer Bestrahlung unter inerter Atmosphäre durchgeführt wird, zum Beispiel unter Helium.

6. Verfahren nach einem der vorstehenden Ansprüche, wobei der Schritt c) einer chemischen Entwicklung durch basische Hydrolyse mit einer wässrigen Lösung von 10 N KOH und 0,25 N KMnO₄ realisiert wird, bei einer Temperatur zwischen 40 °C und 75 °C, zum Beispiel zwischen 40 °C und 70 °C, und vorzugsweise bei 65 °C.

7. Verfahren nach einem der vorstehenden Ansprüche, umfassend die folgenden Schritte:
A) Umsetzen der Schritte a) bis e), wobei der Schritt b) mit einer Fluenz zwischen 10³ Ionen/cm² und 5,10⁹ Ionen/cm² realisiert wird, vorzugsweise zwischen 10³ Ionen/cm² und 10⁸ Ionen/cm², und der Schritt e) eines Elektroplattierens, der Nanodrähte (15) bildet, die mit einem ersten elektrisch halbleitenden oder leitenden Material realisiert werden;
B) Wiederholen der Schritte b) und c), was es ermöglicht, weitere Nanoporen (130) zu realisieren, wobei der Schritt b) mit einer Fluenz zwischen 10³ Ionen/cm² und 5,10⁹ Ionen/cm² realisiert wird, vorzugsweise zwischen 10³ Ionen/cm² und 10⁸ Ionen/cm²;
C) Entfernen der Schicht (14) aus elektrisch leitendem Material, die in Schritt d) aufgebracht wurde;
D) Umsetzen des Schrittes f), sodass eine Schicht (16) aus elektrisch leitendem Material, die nicht in Kontakt mit den Nanodrähten (15, 15', 15") ist, auf einer äußeren Hauptschicht der Membran definiert wird;
E) Wiederholen des Schrittes e) eines Elektroplattierens, um weitere Nanodrähte (150) in den weiteren Nanoporen (130) mit einem zweiten elektrisch halbleitenden oder leitenden Material zu bilden, das sich vom ersten elektrisch halbleitenden oder leitenden Material unterscheidet;
F) Wiederholen des Schrittes d).

8. Verfahren nach einem der Ansprüche 1 bis 6, umfassend die folgenden Schritte:
A') Umsetzen der Schritte a) bis d), wobei der Schritt a) mit einer ersten Membran realisiert wird, die Quellmembran (MSO) genannt wird;
B') Umsetzen der Schritte a) bis c), wobei der Schritt a) mit einer weiteren Membran realisiert wird, die Objektmembran (MOB) genannt wird;
C') Aufbringen der nach dem Schritt B') erhaltenen Objektmembran auf die nach dem Schritt A') erhaltenen Quellmembran;
D') Umsetzen des Schrittes e), wobei dieser Schritt eines Elektroplattierens es ermöglicht, jede der Nanoporen (13) teilweise zu füllen, die durch die Assoziation von mindestens einer Nanopore der nach dem Schritt B') erhaltenen Objektmembran gebildet werden, wobei die Nanopore sich mindestens einer Nanopore der nach dem Schritt A') erhaltenen Quellmembran überlagert, um Nanodrähte (15) zu bilden, die mit einem ersten elektrisch halbleitenden oder leitenden Material realisiert sind, wobei die weiteren Nanoporen (130) nicht gefüllt sind;
E') Trennen der zwei Membranen voneinander;
F') Umsetzen des Schrittes f) auf der nach dem Schritt E') erhaltenen Objektmembran, sodass eine elektrisch leitende Schicht, die nicht in Kontakt mit den Nanodrähten (15) ist, auf einer äußeren Hauptschicht der Membran definiert wird;
G') Umsetzen des Schrittes e) eines Elektroplattierens auf der nach dem Schritt F') erhaltenen Objektmembran, um Nanodrähte (150) in den weiteren Nanoporen (130) mit einem zweiten elektrisch halbleitenden oder leitenden Material zu bilden, das sich vom ersten halbleitenden oder leitenden Material unterscheidet;
H') Umsetzen des Schrittes d) auf der nach dem Schritt G') erhaltenen Objektmembran.

9. Verfahren nach einem der Ansprüche 7 oder 8, wobei:
- das erste Material, das Nanodrähte (15) bildet, ein halbleitendes Material ist, das photovoltaische Eigenschaften aufweist;
- das zweite Material, das die weiteren Nanodrähte (150) bildet, ein halbleitendes Material ist, das thermoelektrische Eigenschaften aufweist.

10. Piezoelektrischer Nanogenerator (110, 110', 110", 110"', 110""), **dadurch gekennzeichnet, dass** er umfasst:
- eine Membran (100) aus polarisiertem β-PVDF oder aus polarisiertem PVDF-TrFe-Copolymer, die folglich piezoelektrische Eigenschaften aufweist, wobei die Membran (100) außerdem zwei äußere Hauptflächen (11, 12) aufweist, die durch eine Dicke e einer Membran getrennt sind;
- eine erste Schicht (14), die aus einem elektrisch leitenden Material realisiert ist, welche die eine (11) der zwei äußeren Hauptflächen der Membran (100) bedeckt;
- eine zweite Schicht (16), die aus einem elektrisch leitenden Material realisiert ist, welche die weitere (12) der zwei äußeren Hauptflächen der Membran (100) bedeckt;
wobei die Membran (100) in ihrer Dicke durch mindestens eine Gesamtheit von elektrisch halbleitenden oder leitenden, zum Beispiel metallischen, Nanodrähten (15, 15', 15") gemäß einer Oberflächendichte zwischen 10³ Nanodrähten/cm² und 10¹⁰ Nanodrähten/cm² nanostrukturiert ist, wobei die Nanodrähte (15, 15', 15") mit der ersten Schicht (14) verbunden sind, aber nicht mit der zweiten Schicht (16), und
wobei die Membran (100) um die Nanodrähte (15, 15', 15") herum, Fehlerbereiche (ZD) umfasst, die durch den Durchgang von Schwerionen durch die ganze Dicke dieser Membran (100) hindurch hinterlassen werden, um Nanoporen zu schaffen, welche die Nanodrähte (15) aufnehmen.

11. Piezoelektrischer Nanogenerator nach dem vorstehenden Anspruch, wobei die Membran (100) in ihrer Dicke nanostrukturiert ist durch:
- eine erste Gesamtheit von elektrisch halbleitenden oder leitenden, zum Beispiel metallischen, Nanodrähten (15, 15', 15"), gemäß einer Oberflächendichte zwischen 10³ Nanodrähten/cm² und 5,10⁹ Nanodrähten/cm², wobei die Nanodrähte (15, 15', 15") mit der ersten Schicht (14) verbunden sind, aber nicht mit der zweiten Schicht (16),
- eine zweite Gesamtheit von elektrisch halbleitenden oder leitenden, zum Beispiel metallischen, Nanodrähten (150), gemäß einer Oberflächendichte zwischen 10³ Nanodrähten/cm² und 5,10⁹ Nanodrähten/cm², wobei die Nanodrähte (150) dieser zweiten Gesamtheit von Nanodrähten (150) mit der zweiten Schicht (16) verbunden sind, aber nicht mit der ersten Schicht (14),
wobei die Membran (100) um die Nanodrähte (15, 15', 15", 150) herum Fehlerbereiche (ZD) umfasst, die durch den Durchgang von Schwerionen durch die ganze Dicke dieser Membran (100) hindurch hinterlassen werden, um Nanoporen zu schaffen, welche die Nanodrähte (15, 15', 15", 150) der beiden Gesamtheiten von Nanodrähten (15, 15', 15", 150) aufnehmen.

12. Piezoelektrischer Nanogenerator nach einem der Ansprüche 10 oder 11, wobei die Nanodrähte der oder der mindestens einen der Gesamtheiten der Nanodrähte (15, 15', 15", 150) aus einem elektrisch leitenden Material eines metallischen Typs realisiert ist, zum Beispiel Au, Zn, Cu, Co, Ni, Ag oder Pt oder einer metallischen Legierung, zum Beispiel gebildet mit den vorgenannten Metallen.

13. Piezoelektrischer Nanogenerator nach einem der Ansprüche 10 bis 12, wobei die Nanodrähte der oder der mindestens einen der Gesamtheiten von Nanodrähten (15, 15', 15", 150) aus einem halbleitenden Material realisiert ist, das photovoltaische Eigenschaften aufweist, zum Beispiel ZnO, oder thermoelektrische, zum Beispiel Bi₂Te₃ oder Sb₂Te₃.

14. Piezoelektrischer Nanogenerator nach einem der Ansprüche 10 bis 13, wobei die Nanodrähte (15, 15', 15", 150) zylindrisch und/oder konisch sind.

15. Piezoelektrischer Nanogenerator nach dem vorstehenden Anspruch, wobei die Nanodrähte (15, 15', 15", 150), zylindrisch, einen Durchmesser zwischen 20 nm und 110 nm aufweisen.

16. Piezoelektrischer Nanogenerator nach einem der Ansprüche 10 bis 15, wobei die Oberflächendichte der Nanodrähte (15, 15', 15", 150) der oder von jeder Gesamtheit von Nanodrähten zwischen 10³ Nanodrähte/cm² und 10⁹ Nanodrähte/cm² ist, zum Beispiel zwischen 10⁶ Nanodrähte/cm² und 10⁹ Nanodrähte/cm².

17. Piezoelektrischer Nanogenerator nach einem der Ansprüche 10 bis 16, wobei die Dicke e der Membran (100) zwischen 1 µm und 60 µm sein kann, zum Beispiel in der Größenordnung von 10 µm, insbesondere 10 µm für β-PVDF und 11 µm für Copolymer P(VDF-TrFe).

18. Vorrichtung (400), **dadurch gekennzeichnet, dass** sie umfasst:
- einen piezoelektrischen Nanogenerator (110, 110', 110", 110'") nach einem der Ansprüche 10 bis 17;
- einen Kondensator (200);
- ein Mittel (300), das zwischen dem piezoelektrischen Nanogenerator und dem Kondensator angeordnet ist, um den Strom, der vom piezoelektrischen Nanogenerator abfließt, zum Kondensator zu übertragen, ohne Möglichkeit einer Rückkehr zum piezoelektrischen Nanogenerator, zum Beispiel eine Graetzbrücke.

19. Vorrichtung nach dem vorstehenden Anspruch, wobei der Kondensator (200) ein Nanokondensator ist, einschließend:
- eine Membran (210), die aus einem elektrisch isolierenden Material realisiert ist, die zwei äußere Hauptflächen (211, 212) aufweist, die durch eine Dicke einer Membran getrennt sind;
- eine erste Schicht (214), die aus einem elektrisch leitenden Material realisiert ist, die eine (211) der zwei äußeren Hauptflächen der Membran bedeckt;
- eine zweite Schicht (216), die aus einem elektrisch leitenden Material realisiert ist, welche die weitere (212) der zwei äußeren Hauptflächen der Membran bedeckt;
wobei die Membran in ihrer Dicke einerseits durch eine erste Gesamtheit von elektrisch halbleitenden oder leitenden, zum Beispiel metallischen, Nanodrähten, die mit der ersten elektrisch leitenden Schicht (214) verbunden sind, aber nicht mit der zweiten elektrisch leitenden Schicht (216), und andererseits durch eine zweite Gesamtheit von elektrisch halbleitenden oder leitenden, zum Beispiel metallischen, Nanodrähten nanostrukturiert ist, die mit der zweiten elektrisch leitenden Schicht (216) verbunden sind, aber nicht mit der ersten elektrisch leitenden Schicht (214), wobei die Nanodrähte der ersten Gesamtheit von Nanodrähten und der zweiten Gesamtheit von Nanodrähten interdigital sind.

20. Vorrichtung nach dem vorstehenden Anspruch, wobei die Membran des Nanokondensators aus einem Material realisiert ist, das ausgewählt ist aus: Polycarbonat (PC), Aluminium (Al₂O₃), Polyethylenterephthalat (PET) oder Polyimid (PI), günstigerweise Kapton®.

21. Vorrichtung nach einem der Ansprüche 19 oder 20, wobei die Nanodrähte einer beliebigen von der ersten und der zweiten Gesamtheit von Nanodrähten metallische Nanodrähte sind, die ausgewählt sind aus: Au, Zn, Cu, Co, Ni, Ag, Pt oder einer metallischen Legierung, insbesondere realisiert aus den vorgenannten Metallen.

## Claims

1. Method for manufacturing a piezoelectric nanogenerator (110, 110', 110", 110"', 110""), **characterised in that** it comprises the following steps:
a) providing a membrane (100) made of polarised β-PVDF or polarised PVDF-TrFe copolymer therefore having piezoelectric properties, said membrane (100) moreover having two external main faces (11, 12) separated by a membrane thickness (e);
b) irradiating said membrane (100) via at least one of the two external main faces (11, 12) thereof through the entire thickness of said membrane with heavy ions having a fluence of between 10³ ions/cm² and 10¹⁰ ions/cm², as a result of which a membrane (101) containing latent traces (TL) of the passage of the heavy ions through the entirety of the thickness of it is obtained;
c) chemically revealing the latent traces (TL) over a predetermined duration to maintain a defect zone (ZD) belonging to the latent trace, as a result of which a nanostructured membrane (102, 102', 102") with nanopores (13, 13' 13") is obtained comprising, around each nanopore (13, 13' 13"), a defect zone (ZD);
d) depositing a layer of an electrically conductive material on one (12) of the two main external faces (11, 12) of said membrane (102, 102', 102");
e) electrodepositing a semiconductor or electrically conductive material in the nanopores (13, 13', 13"), the electrodeposition being stopped before the nanopores (13, 13' 13") have been completely filled, as a result of which a nanostructured membrane (103, 103', 103") is obtained having nanowires (15, 15', 15") partially filling the nanopores (13, 13' 13"); and
f) depositing a layer of an electrically conductive material on the other (11) of the two main external faces (11, 12), which therefore is not in contact with the nanowires.

2. Method according to claim 1, wherein for irradiating, during step b), said membrane through the entire thickness of it, the heavy ions have an energy between 2MeV/amu and 15MeV/amu.

3. Method according to one of the preceding claims, wherein step b) of irradiating is carried out with heavy ions of the Kr or Xe type.

4. Method according to one of the preceding claims, wherein step b) of irradiating is carried out with heavy ions of which the fluence is of between 10³ ions/cm² and 10⁹ ions/cm², for example of between 10⁶ ions/cm² and 10⁹ ions/cm².

5. Method according to one of the preceding claims. wherein step b) of irradiating is carried out under an inert atmosphere, for example under helium.

6. Method according to one of the preceding claims, wherein step c) of chemically revealing is carried out by basic hydrolysis with an aqueous solution of KOH at 10N and KMnO₄ at 0.25N, at a temperature of between 40°C and 75°C, for example of between 40°C and 70°C, and preferably at 65°C.

7. Method according to one of the preceding claims, comprising the following steps:
A) implementing steps a) to c), where step b) is carried out with a fluence of between 10³ ions/cm² and 5.10⁹ ions/cm², preferably of between 10³ ions/cm² and 10⁸ ions/cm², and step e) of electrodepositing forming nanowires (15) being carried out with a first semiconductor or electrically conductive material;
B) repeating steps b) and c), which makes it possible to produce other nanopores (130), step b) being carried out with a fluence of between 10³ ions/cm² and 5.10⁹ ions/cm², preferably of between 10³ ions/cm² and 10⁸ ions/cm²;
C) suppressing the layer (14) made of electrically conductive material deposited in step d);
D) implementing step 1), in that a layer (16) made of electrically conductive material is defined, which is not in contact with the nanowires (15, 15' 15"), on a main external face of said membrane;
E) repeating step e) of electrodepositing to form other nanowires (150) in said other nanopores (130) with a second semiconductor or electrically conductive material, different from the first semiconductor or electrically conductive material;
F) repeating step d).

8. Method according to one of claims 1 to 6, comprising the following steps:
A') implementing steps a) to d), step a) being carried out with a first membrane referred to as source membrane (MSO);
B') implementing steps a) to c), step a) being carried out with another membrane referred to as object membrane (MOB);
C') arranging the object membrane obtained at the end of step B') on the source membrane obtained at the end of step A');
D') implementing step e), this step of electrodepositing making it possible to partially fill each one of the nanopores (13) formed by the association of at least one nanopore of the object membrane obtained at the end of step B'), said nanopore is superimposed on at least one nanopore of the source membrane obtained at the end of step A') in order to form nanowires (15) carried out with a first semiconductor or electrically conductive material, with the other nanopores (130) not being filled;
E') separating the two membranes from one another;
F') implementing step f) on the object membrane obtained at the end of step E') in that an electrically conductive layer is defined, which is not in contact with the nanowires (15), on a main external face of said membrane;
G') implementing step e) of electrodepositing on the object membrane obtained at the end of step F') to form nanowires (150) in said other nanopores (130) with a second semiconductor or electrically conductive material, different from the first semiconductor or electrically conductive material;
H') implementing step d) on the object membrane obtained at the end of step G').

9. Method according to one of claims 7 or 8, wherein:
- the first material forming nanowires (15) is a semiconductor material that has photovoltaic properties;
- the second material forming the other nanowires (150) is a semiconductor material that has thermoelectric properties.

10. Piezoelectric nanogenerator (110, 110', 110", 110"', 110""), **characterised in that** it comprises:
- a membrane (100) made of polarised β-PVDF or polarised PVDF-TrFe copolymer therefore having piezoelectric properties, said membrane (100) moreover having two external main faces (11, 12) separated by a membrane thickness e;
- a first layer (14) made from an electrically conductive material that covers one (11) of the two main external faces of the membrane (100);
- a second layer (16) made from an electrically conductive material that covers the other (12) of the two main external faces of the membrane (100);
said membrane (100) being, in the thickness thereof, nanostructured by at least one set of semiconductor or electrically conductive nanowires (15, 15', 15"), for example metal, according to a surface density of between 10³ nanowires/cm² and 10¹⁰ nanowires/cm², said nanowires (15, 15', 15") being connected to the first layer (14) but not to the second layer (16), and
said membrane (100) comprising, around nanowires (15, 15', 15"), defect zones (ZD) left by the passage of heavy ions through the entire thickness of this membrane (100) to create nanopores that receive said nanowires (15).

11. Piezoelectric nanogenerator according to the preceding claim, wherein the membrane (100) is, in the thickness thereof, nanostructured by:
- a first set of semiconductor or electrically conductive nanowires (15, 15', 15"), for example metal, according to a surface density of between 10³ nanowires/cm² and 5.10⁹ nanowires/cm², said nanowires (15, 15', 15") being connected to the first layer (14) but not to the second layer (16),
- a second set of semiconductor or electrically conductive nanowires (150), for example metal, according to a surface density of between 10³ nanowires/cm² and 5.10⁹ nanowires/cm², said nanowires (150) of this second set of nanowires (150) being connected to the second layer (16) but not to the first layer (14),
said membrane (100) comprising, around nanowires (15, 15', 15", 150), defect zones (ZD) left by the passage of heavy ions through the entire thickness of this membrane (100) in order to create nanopores that receive said nanowires (15, 15', 15", 150) of the two sets of nanowires (15, 15', 15", 150).

12. Piezoelectric nanogenerator according to one of claims 10 or 11, wherein the nanowires of the or of at least one of the sets of nanowires (15, 15' 15", 150) is made from an electrically conductive material of the metal type, for example Au, Zn, Cu, Co, Ni, Ag or Pt or a metal alloy, for example formed with the aforementioned metals.

13. Piezoelectric nanogenerator according to one of claims 10 to 12, wherein the nanowires of the or of at least one of the sets of nanowires (15, 15', 15" 150) is made from a semiconductor material that has photovoltaic properties, for example ZnO, or thermoelectric properties, for example Bi₂Te₃ or Sb₂Te₃.

14. Piezoelectric nanogenerator according to one of claims 10 to 13, wherein the nanowires (15, 15', 15", 150) are cylindrical and/or conical.

15. Piezoelectric nanogenerator according to the preceding claim, wherein the cylindrical nanowires (15, 15', 15", 150), have a diameter of between 20nm and 110nm.

16. Piezoelectric nanogenerator according to one of claims 10 to 15, wherein the surface density of the nanowires (15, 15', 15", 150) of the or of each set of nanowires is of between 10³ nanowires/cm² and 10⁹ nanowires/cm² 1, for example of between 10⁶ nanowires/cm² and 10⁹ nanowires/cm².

17. Piezoelectric nanogenerator according to one of claims 10 to 16, wherein the thickness e of the membrane (100) can be of between 1µm and 60µm, for example about 10µm, in particular 10µm for β-PVDF and 11µm for P(VDF-TrFE) copolymer.

18. Device (400) **characterised in that** it comprises:
- a piezoelectric nanogenerator (110, 110', 110", 110'") according to one of claims 10 to 17;
- a capacitor (200);
- a means (300), arranged between the piezoelectric nanogenerator and the capacitor, for transferring the current exiting the piezoelectric nanogenerator to the capacitor without a possibility of returning to the piezoelectric nanogenerator, for example a Graetz bridge.

19. Device according to the preceding claim, wherein the capacitor (200) is a nanocapacitor comprising:
- a membrane (210), made from an electrically insulated material, having two main external faces (211, 212) separated by a membrane thickness;
- a first layer (214) made from an electrically conductive material covering one (211) of the two main external faces of the membrane;
- a second layer (216) made from an electrically conductive material covering the other (212) of the two main external faces of the membrane;
said membrane being, in the thickness thereof, nanostructured on the one hand, by a first set of semiconductor or electrically conductive nanowires, for example metal, connected to the first electrically conductive layer (214) but not to the second electrically conductive layer (216) and on the other hand, by a second set of semiconductor or electrically conductive nanowires, for example metal, connected to the second electrically conductive layer (216) but not to the first electrically conductive layer (214), said nanowires of the first set of nanowires and of the second set of nanowires being interdigitated.

20. Device according to the preceding claim, wherein the membrane of the nanocapacitor is made from a material selected from among: polycarbonate (PC), alumina (Al₂O₃), polyethylene terephthalate (PET) or polyimide (PI), advantageously Kapton®.

21. Device according to one of claims 19 or 20, wherein the nanowires of any of the first and of the second set of nanowires are metal nanowires selected from among: Au, Zn, Cu, Co. Ni, Ag, Pt or a metal alloy, in particular made from the aforementioned metals.
